# EUROPEAN PATENT APPLICATION

(11) **EP 4 653 507 A1**
(43) Date of publication of application: **26.11.2025**
(21) Application number: 24744625.5
(22) Date of filing: 15.01.2024
(51) Int. Cl.: C09J 183/05, C09J 7/35, C09J 183/07, H01L 21/02

(54) **ADHESIVE COMPOSITION, LAMINATE, AND METHOD FOR PRODUCING PROCESSED SEMICONDUCTOR SUBSTRATE**

(30) Priority: 18.01.2023 JP 2023005953
(71) Applicant: Nissan Chemical Corporation, Tokyo 103-6119 (JP)
(72) Inventor: USUI, Yuki, Toyama-shi, Toyama 939-2792 (JP); OKUNO, Takahisa, Toyama-shi, Toyama 939-2792 (JP); YANAI, Masaki, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2024/000849
(87) International publication number: WO 2024/154702

(57) **Abstract**

An adhesive composition cured by a hydrosilylation reaction, containing a platinum group metal-based catalyst and a compound represented by Formula (1) below. 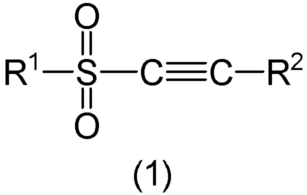 (In Formula (1), R¹ and R² each independently represent a monovalent group.)

## Description

### Technical Field

The present invention relates to an adhesive composition, a laminate, and a method for producing a processed semiconductor substrate.

### Background Art

For a semiconductor wafer that has been conventionally integrated in a two-dimensional planar direction, a semiconductor integration technology is required by which a planar surface is further integrated (laminated) also in a three-dimensional direction for the purpose of further integration. This three-dimensional lamination is a technology of integrating multiple layer while connecting the layers by a through silicon via (TSV). At the time of multilayer integration, respective wafers to be integrated are thinned by polishing the side opposite to the formed circuit surface (that is, the back surface), and the thinned semiconductor wafers are laminated.

A pre-thinned semiconductor wafer (also referred to herein simply as a wafer) is adhered to a support in order to be polished with a polishing apparatus. The adhesion at that time need to be easily released after polishing, and therefore is referred to as temporary adhesion. This temporary adhesion must allow for easy removal from the support. Otherwise, the thinned semiconductor wafer may be cut or deformed when a large force is applied for the removal. The removal is easily performed such that such a situation does not occur. On the other hand, at the time of polishing the back surface of the semiconductor wafer, it is not preferable that the semiconductor wafer is detached or displaced due to polishing stress. Therefore, the performance required for temporary adhesion is to withstand the stress during polishing and to allow for easy removal after polishing.

As the temporary adhesive used for such temporary adhesion, a temporary adhesive containing a component that cures by a hydrosilylation reaction is used. As a temporary adhesive, for example, a temporary adhesive containing a component (A) cured by a hydrosilylation reaction, a polymerization inhibitor (B) having a 5% mass reduction temperature at Tg-DTA of 80°C or higher, and a solvent (C) has been proposed (refer to Patent Literature 1). In this proposed technique, an acetylenic alcohol such as 1,1-diphenyl-2-propyne-1-ol is used as the polymerization inhibitor (B). The polymerization inhibitor is also called a crosslinking inhibitor or a reaction inhibitor.

### Citation List

### Patent Literature

Patent Literature 1: WO 2019/212008 A

### Summary of Invention

### Technical Problem

When a semiconductor wafer and a support are bonded to each other via a temporary adhesive, the semiconductor wafer and the support may be bonded to each other while being heated. At that time, when the curing start temperature of the temporary adhesive is low, curing may proceed before sufficient bonding, and appropriate bonding may not be performed.

The present invention has been made in view of the above circumstances, and an object thereof is to provide an adhesive composition capable of increasing a curing start temperature, a laminate using the adhesive composition, and a method for producing a processed semiconductor substrate or an electronic device layer using the laminate.

### Solution to Problem

As a result of intensive studies to solve the above problem, the present inventors have found that the above problem can be solved, and completed the present invention having the following gist.

That is, the present invention includes the following aspects.
[1] An adhesive composition cured by a hydrosilylation reaction, containing
   a platinum group metal-based catalyst and a compound represented by Formula (1) below: 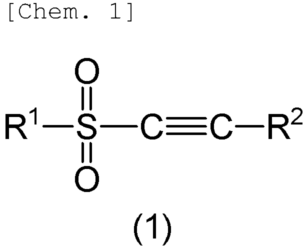
   wherein in Formula (1), R¹ and R² each independently represent a monovalent group.
[2] The adhesive composition according to [1], in which R¹ in the Formula (1) represents an organic group having 1 to 20 carbon atoms.
[3] The adhesive composition according to [1] or [2], in which R² in Formula (1) represents a hydrogen atom, a halogen atom, or an organic group having 1 to 20 carbon atoms.
[4] The adhesive composition according to any one of [1] to [3], further containing: a component (A-1) having an alkenyl group having 2 to 40 carbon atoms bonded to a silicon atom; and a component (A-2) having an Si-H group.
[5] The adhesive composition according to [4], in which the component (A-1) contains a polyorganosiloxane (a1) containing an alkenyl group having 2 to 40 carbon atoms bonded to a silicon atom.
[6] The adhesive composition according to [4] or [5], in which the component (A-2) contains a polyorganosiloxane containing a Si-H group.
[7] A laminate including:
   a semiconductor substrate or an electronic device layer;
   a light-transmissive support substrate; and
   an adhesive layer provided between the semiconductor substrate or the electronic device layer and the support substrate, in which
   the adhesive layer is an adhesive layer formed from the adhesive composition according to any one of [1] to [6].
[8] The laminate according to [7], further including a release agent layer provided between the semiconductor substrate or the electronic device layer and the support substrate.
[9] A method for producing a processed semiconductor substrate or a processed electronic device layer, the method including:
   Step 5A of processing the semiconductor substrate of the laminate according to [7] or [8], or Step 5B of processing the electronic device layer of the laminate according to [7] or [8]; and
   Step 6A of separating the semiconductor substrate processed in the Step 5A and the support substrate from each other, or Step 6B of separating the electronic device layer processed in the Step 5B and the support substrate from each other.

### Advantageous Effects of Invention

According to the present invention, it is possible to provide an adhesive composition capable of increasing a curing start temperature, a laminate using the adhesive composition, and a method for producing a processed semiconductor substrate or an electronic device layer using the laminate.

### Brief Description of Drawings

Fig. 1 is a schematic cross-sectional view of an example of a laminate in a first embodiment.
Fig. 2 is a schematic cross-sectional view of another example of the laminate in the first embodiment.
Fig. 3A is a schematic cross-sectional view for describing a method for producing a laminate showing an example in the first embodiment (part 1).
Fig. 3B is a schematic cross-sectional view for describing the method for producing a laminate showing an example in the first embodiment (part 2).
Fig. 4 is a schematic cross-sectional view of an example of a laminate in a second embodiment.
Fig. 5 is a schematic cross-sectional view of another example of the laminate in the second embodiment.
Fig. 6A is a schematic cross-sectional view for describing a method for producing a laminate showing an example in the second embodiment (part 1).
Fig. 6B is a schematic cross-sectional view for describing a method for producing a laminate showing an example in the second embodiment (part 2).
Fig. 6C is a schematic cross-sectional view for describing a method for producing a laminate showing an example in the second embodiment (part 3).
Fig. 7A is a schematic cross-sectional view for describing a method for processing a laminate showing an example in the first embodiment (part 1).
Fig. 7B is a schematic cross-sectional view for describing the method for processing a laminate showing an example in the first embodiment (part 2).
Fig. 7C is a schematic cross-sectional view for showing the method for processing a laminate showing an example in the first embodiment (part 3).
Fig. 7D is a schematic cross-sectional view for describing the method for processing a laminate showing an example in the first embodiment (part 4).
Fig. 8A is a schematic cross-sectional view for describing a method for processing a laminate showing an example in the second embodiment (part 1).
Fig. 8B is a schematic cross-sectional view for describing a method for processing a laminate showing an example in the second embodiment (part 2).
Fig. 8C is a schematic cross-sectional view for describing a method for processing a laminate showing an example in the second embodiment (part 3).
Fig. 8D is a schematic cross-sectional view for describing a method for processing a laminate showing an example in the second embodiment (part 4).
Fig. 8E is a schematic cross-sectional view for describing a method for processing a laminate showing an example in the second embodiment (part 5).
Fig. 8F is a schematic cross-sectional view for describing a method for processing a laminate showing an example in the second embodiment (part 6).

### Description of Embodiments

### (Adhesive Composition)

An adhesive composition of the present invention is an adhesive composition cured by a hydrosilylation reaction.

The adhesive composition contains a platinum group metal-based catalyst and a compound represented by Formula (1).

The adhesive composition preferably contains a component (A-1) having an alkenyl group having 2 to 40 carbon atoms bonded to a silicon atom (hereinafter may be referred to as a component (A-1)).

The adhesive composition preferably contains a component (A-2) having an Si-H group (hereinafter may be referred to as a component (A-2)).

The present inventors have found that the curing start temperature can be increased by including the compound represented by Formula (1) in an adhesive composition that is cured by a hydrosilylation reaction using a platinum group metal-based catalyst as a catalyst, leading to the present invention.

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenolic resin-based adhesive.

Among them, a polysiloxane-based adhesive is preferable as the adhesive composition because the adhesive composition exhibits suitable adhesive function during processing of the semiconductor substrate or the like, can be suitably released after processing, is further excellent in heat resistance, and can be suitably removed by the cleaning agent composition.

In a preferable aspect, the adhesive composition contains a polyorganosiloxane.

### <Compound Represented by Formula (1)>

The adhesive composition contains a compound represented by the following Formula (1). 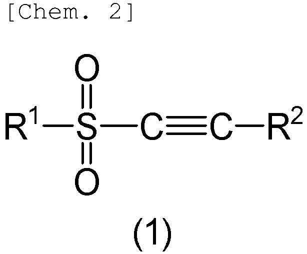 (In Formula (1), R¹ and R² each independently represent a monovalent group.)

### <<R¹>>

In R¹ in Formula (1), an atom directly bonded to the sulfur atom (S) in Formula (1) is, for example, a carbon atom.

R¹ in Formula (1) is preferably an organic group having 1 to 20 carbon atoms, and more preferably a hydrocarbon group having 1 to 20 carbon atoms, which may have a substituent, from the viewpoint of suitably obtaining the effect of the present invention. Examples of the substituent in the hydrocarbon group having 1 to 20 carbon atoms which may have a substituent include a halogen atom, a hydroxy group, a carboxy group, and an alkoxy group having 1 to 6 carbon atoms.

In the present invention, examples of the halogen atom include a fluorine atom, a chlorine atom, a bromine atom, and an iodine atom.

R¹ in Formula (1) is preferably a group represented by the following Formula (1A) from the viewpoint of suitably obtaining the effect of the present invention. 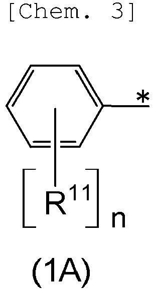
(In Formula (1A), R¹¹ represents a group formed by one or more atoms selected from the group consisting of a hydrogen atom, a carbon atom, an oxygen atom, a nitrogen atom, a sulfur atom, a phosphorus atom, a silicon atom, and a halogen atom.
n represents an integer of 0 to 5.
When there are two or more R¹¹'s, the two or more R¹¹'s may be identical or different.)

The number of carbon atoms of the group represented by Formula (1A) is, for example, 6 to 20.

The number of carbon atoms of R¹¹ in Formula (1A) is, for example, 0 to 10.

Examples of R¹¹ in Formula (1A) include a halogen atom, a hydroxy group, a carboxy group, a cyano group, a nitro group, an alkyl group having 1 to 10 carbon atoms which may have a substituent, and an alkoxy group having 1 to 10 carbon atoms which may have a substituent.

Examples of the substituents in the alkyl group having 1 to 10 carbon atoms, which may have a substituent, and the alkoxy group having 1 to 10 carbon atoms, which may have a substituent, include a halogen atom. a hydroxy group, a carboxy group, and an alkoxy group having 1 to 6 carbon atoms.

### <<R²>>

Examples of R² in Formula (1) include a group formed by one or more atoms selected from the group consisting of a hydrogen atom, a carbon atom, an oxygen atom, a nitrogen atom, a sulfur atom, a phosphorus atom, a silicon atom, and a halogen atom.

The number of atoms of R² in Formula (1) is not particularly limited, and may be 1 to 50.

The number of carbon atoms of R² in Formula (1) is not particularly limited, and is, for example, 0 to 20.

R² in Formula (1) is preferably a hydrogen atom, a halogen atom, or an organic group having 1 to 20 carbon atoms from the viewpoint of suitably obtaining the effect of the present invention.

Examples of the organic group having 1 to 20 carbon atoms include a hydrocarbon group having 1 to 20 carbon atoms which may have a substituent. Examples of the substituent in the hydrocarbon group having 1 to 20 carbon atoms which may have a substituent include a halogen atom, a hydroxy group, a carboxy group, and an alkoxy group having 1 to 6 carbon atoms.

Examples of the compound represented by Formula (1) include the following compounds.

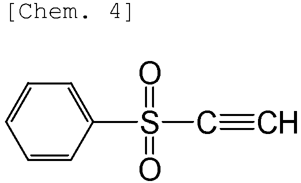

The content of the compound represented by Formula (1) in the adhesive composition is not particularly limited, but is usually 500.0 ppm by mass or more with respect to the total amount of the component (A-1) and the component (A-2) from the viewpoint of obtaining the effect, and is 10,000.0 ppm by mass or less from the viewpoint of preventing excessive suppression of the hydrosilylation reaction.

### <<Platinum Group Metal-Based Catalyst>>

The platinum group metal-based catalyst is a platinum-based metal catalyst.

Such a platinum-based metal catalyst is a catalyst for promoting the hydrosilylation reaction between the alkenyl group and the Si-H group.

As a specific example of the platinum-based metal catalyst, a catalyst known as a platinum-based compound (platinum or a compound containing platinum) can be used.

Specific examples thereof include platinum fine powder, platinum black, chloroplatinic acid, an alcohol modified product of chloroplatinic acid, a complex of chloroplatinic acid and diolefin, a platinum-olefin complex, a platinum-carbonyl complex [platinum bis(acetoacetate), platinum bis(acetylacetonate), or the like], a chloroplatinic acid-alkenylsiloxane complex (chloroplatinic acid-divinyltetramethyldisiloxane complex, chloroplatinic acid-tetravinyltetramethylcyclotetrasiloxane complex, or the like), a platinum-alkenylsiloxane complex (platinum-divinyltetramethyldisiloxane complex, platinum-tetravinyltetramethylcyclotetrasiloxane complex, or the like), and a complex of chloroplatinic acid and an acetylene alcohol. Among these, a platinum-alkenylsiloxane complex is particularly preferable since a hydrosilylation reaction-promoting effect is high.

These hydrosilylation reaction catalysts may be used alone or in combination of two or more thereof.

The alkenylsiloxane used in the platinum-alkenylsiloxane complex is not particularly limited, and examples thereof include: 1,3-divinyl-1,1,3,3-tetramethyldisiloxane; 1,3,5,7-tetramethyl-1,3,5,7-tetravinylcyclotetrasiloxane; alkenylsiloxane oligomers in which some of the methyl groups of the alkenylsiloxane are substituted with ethyl groups; phenyl groups, or the like; and alkenylsiloxane oligomers in which the vinyl groups of these alkenylsiloxanes are substituted with allyl groups, hexenyl groups, or the like. In particular, 1,3-divinyl-1,1,3,3-tetramethyldisiloxane is preferable since the platinum-alkenylsiloxane complex to be produced has good stability.

The content of the platinum group metal-based catalyst in the adhesive composition is not particularly limited but is, for example, in a range of 0.1 to 50.0ppm with respect to the total mass of the component (A-1) and the component (A-2).

### <Component (A-1) and Component (A-2)>

The adhesive composition preferably contains the component (A-1).

The adhesive composition preferably contains the component (A-2).

Hereinafter, the combination of the component (A-1), the component (A-2), the platinum group metal-based catalyst, and the compound represented by Formula (1) may be referred to as "component (A) to be cured" or "component (A)".

The component (A-1) preferably contains a polyorganosiloxane (a1) containing an alkenyl group having 2 to 40 carbon atoms bonded to a silicon atom from the viewpoint of suitably obtaining the effect of the present invention.

The component (A-2) preferably contains a polyorganosiloxane (a2) having an Si-H group from the viewpoint of suitably obtaining the effect of the present invention.

Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

In another preferable aspect, the adhesive composition to be cured by the hydrosilylation reaction includes: a polysiloxane (A1) containing one or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}; a platinum group metal-based catalyst (A2); and a compound represented by Formula (1). The polysiloxane (A1) includes: a polyorganosiloxane (a1') containing one or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴' R⁵' SiO_{2/2}, and a siloxane unit (T' unit) represented by R⁶'SiO_{3/2}, and also containing at least one selected from the group consisting of M' units, D' units, and T' units; and a polyorganosiloxane (a2') containing one or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and also containing at least one selected from the group consisting of M" units, D" units, and T" units.

Note that (a1') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom and each independently represent an optionally substituted alkyl group or an optionally substituted alkenyl group, provided that at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom, and each independently represent an optionally substituted alkyl group or a hydrogen atom, provided that at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, but is preferably a linear or branched alkyl group, and the number of carbon atoms thereof is not particularly limited, but is usually 1 to 40, preferably 30 or less, more preferably 20 or less, and still more preferably 10 or less.

Specific examples of the optionally substituted linear or branched alkyl group include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the optionally substituted cyclic alkyl group include, but are not limited to, a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 to 6.

The alkenyl group may be linear or branched, and the number of carbon atoms thereof is not particularly limited, but is usually 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl, and the number of carbon atoms thereof is usually 4 to 14, preferably 5 to 10, and more preferably 5 to 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed. At that time, the compound represented by Formula (1) coexists, and accordingly, the curing start temperature is increased.

The polyorganosiloxane (a1') contains one or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more types of polyorganosiloxanes satisfying such conditions may be used in combination.

Examples of preferable combinations of two or more types selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, when two or more types of polyorganosiloxanes included in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combinations are not limited thereto.

The polyorganosiloxane (a2') contains one or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more types of polyorganosiloxanes satisfying such conditions may be used in combination.

Examples of preferable combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms of the polyorganosiloxane, and the proportion of alkenyl groups in all substituents represented by R¹' to R⁶' is preferably 0.1 to 50.0 mol%, more preferably 0.5 to 30.0 mol%, and the remaining R¹' to R⁶' can be alkyl groups.

The polyorganosiloxane (a2') is composed of siloxane units in which alkyl groups and/or hydrogen atoms are bonded to silicon atoms of the polyorganosiloxane, and the proportion of hydrogen atoms in all substituents and substitutional atoms represented by R¹" to R⁶" is preferably 0.1 to 50.0 mol%, more preferably 10.0 to 40.0 mol%, and the remaining R¹" to R⁶" can be alkyl groups.

When the adhesive composition contains (a1) and (a2), in a preferable aspect of the present invention, the molar ratio of the alkenyl group contained in the polyorganosiloxane (a1) and the hydrogen atom constituting the Si-H bond contained in the polyorganosiloxane (a2) is in the range of 1.0:0.5 to 1.0:0.66.

The weight average molecular weight of the polysiloxane such as the polyorganosiloxane (a1) or the polyorganosiloxane (a2) is not particularly limited, but each is typically 500 to 1,000,000, and is preferably 5,000 to 50,000 from the viewpoint of achieving the effects of the present invention with good reproducibility.

Note that in the present invention, the weight average molecular weight, the number average molecular weight, and the dispersibility of the polyorganosiloxane (excluding the organosiloxane polymer) can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (eluent solvent), at a flow rate of 0.35 mL/min, and using polystyrene (Shodex manufactured by Showa Denko K.K.) as a standard sample.

The viscosity of the polyorganosiloxane (a1) and the polyorganosiloxane (a2) is not particularly limited, but each is usually 10 to 1,000,000 (mPa·s), and is preferably 50 to 10,000 (mPa·s) from the viewpoint of achieving the effects of the present invention with good reproducibility. The viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Accordingly, the mechanism of curing is different from a mechanism, for example, through silanol groups, and therefore, any siloxane does not need to contain a silanol group or a functional group that forms a silanol group by hydrolysis, such as an alkyloxy group.

An example of the adhesive composition used in the present invention may contain a component (hereinafter may be referred to as a component (B).) that does not cause a hydrosilylation reaction as a release agent component together with the component (A) that cures. Here, examples of the component (B) include a polyorganosiloxane. By including such a component (B) in the adhesive composition, the obtained adhesive layer can be suitably released with good reproducibility.

Typical examples of the component (B) include a non-curable polyorganosiloxane, and specific examples thereof include, but are not limited to, an epoxy group-containing polyorganosiloxane, a methyl group-containing polyorganosiloxane, and a phenyl group-containing polyorganosiloxane.

Examples of the component (B) include polydimethylsiloxane. The polydimethylsiloxane may be modified. Examples of the optionally modified polydimethylsiloxane includes, but are not limited to, an epoxy group-containing polydimethylsiloxane, an unmodified polydimethylsiloxane, or a phenyl group-containing polydimethylsiloxane.

Preferable examples of the polyorganosiloxane as the component (B) include, but are not limited to, an epoxy group-containing polyorganosiloxane, a methyl group-containing polyorganosiloxane, and a phenyl group-containing polyorganosiloxane.

The weight average molecular weight of the polyorganosiloxane as the component (B) is not particularly limited, but is usually 100,000 to 2,000,000, preferably 200,000 to 1,200,000, and more preferably 300,000 to 900,000 from the viewpoint of achieving the effects of the present invention with good reproducibility. In addition, the dispersibility is not particularly limited, but is usually 1.0 to 10.0, preferably 1.5 to 5.0, and more preferably 2.0 to 3.0 from the viewpoint of achieving suitable release with good reproducibility. Note that the weight average molecular weight and the dispersibility can be measured by the above-described method related to the polyorganosiloxane.

The viscosity of the polyorganosiloxane as the component (B) is not particularly limited, but is usually 1,000 to 2,000,000 mm²/s. Note that the value of the viscosity of the polyorganosiloxane as the component (B) is expressed by kinematic viscosity, and centistokes (cSt) = mm²/s. The value can also be determined by dividing the viscosity (mPa·s) by the density (g/cm³). That is, the value can be determined from the viscosity and density measured with an E-type rotational viscometer at 25°C, and can be calculated from the equation: kinematic viscosity (mm²/s) = viscosity (mPa·s) /density (g/cm³).

Examples of the epoxy group-containing polyorganosiloxane include those containing a siloxane unit (D¹⁰ unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group can include the above-described examples.

The epoxy group in the organic group containing an epoxy group may be an independent epoxy group without being fused with another ring, or may be an epoxy group forming a fused ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferable examples of the epoxy group-containing polyorganosiloxane may include, but are not limited to, an epoxy group-containing polydimethylsiloxane.

The epoxy group-containing polyorganosiloxane contains the above-described siloxane unit (D¹⁰ unit), but may contain, in addition to the D¹⁰ unit, a Q unit, a M unit, and/or a T unit.

In a preferable aspect of the present invention, specific examples of the epoxy group-containing polyorganosiloxane include a polyorganosiloxane composed only of a D¹⁰ unit, a polyorganosiloxane containing a D¹⁰ unit and a Q unit, a polyorganosiloxane containing a D¹⁰ unit and an M unit, a polyorganosiloxane containing a D¹⁰ unit and a T unit, a polyorganosiloxane containing a D¹⁰ unit, a Q unit, and an M unit, a polyorganosiloxane containing a D¹⁰ unit, an M unit, and a T unit, or a polyorganosiloxane containing a D¹⁰ unit, a Q unit, an M unit, and a T unit.

The epoxy group-containing polyorganosiloxane is preferably an epoxy group-containing polydimethylsiloxane having an epoxy value of 0.1 to 5. In addition, the weight average molecular weight is not particularly limited, but is usually from 1,500 to 500,000, and is preferably 100,000 or less from the viewpoint of suppressing precipitation in the composition.

Specific examples of the epoxy group-containing polyorganosiloxane include, but are not limited to, those represented by Formulas (E1) to (E3). 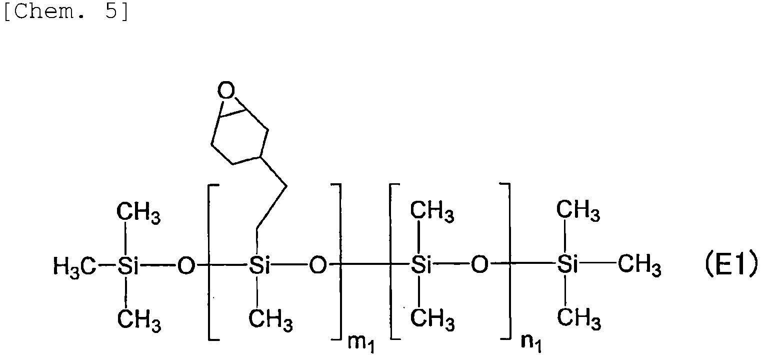 (m₁ and n₁ represent the number of respective repeating units, and are positive integers.) 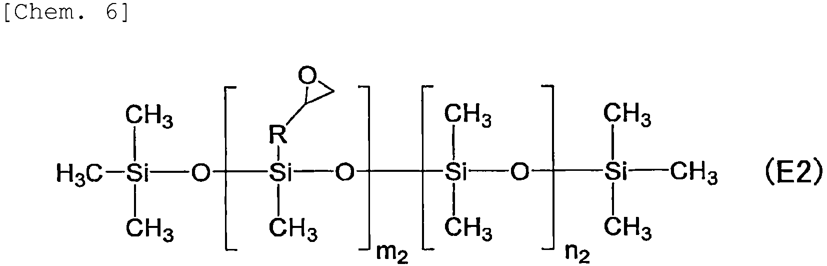 (m₂ and n₂ represent the number of respective repeating units, and are positive integers, and R is an alkylene group having 1 to 10 carbon atoms.) 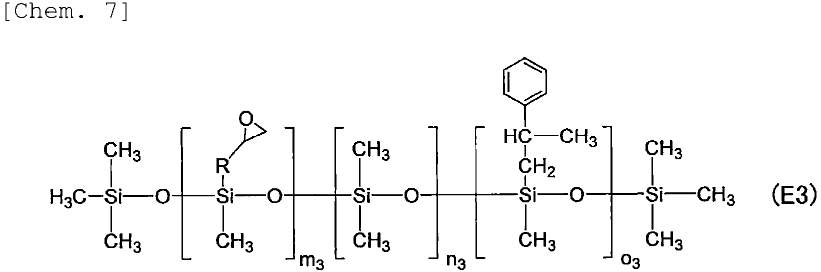 (m₃, n₃, and o₃ represent the number of respective repeating units, and are positive integers, and R is an alkylene group having 1 to 10 carbon atoms.)

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²¹R²¹SiO_{2/2}.

R²¹⁰ and R²²⁰ are groups bonded to silicon atoms, and each independently represent an alkyl group, with at least one of R²¹⁰ and R²²⁰ being a methyl group, and specific examples of the alkyl group may include the above-described examples.

R²¹ is a group bonded to a silicon atom and represents an alkyl group, and specific examples of the alkyl group may include the above-described examples. Among them, a methyl group is preferable as R²¹.

In the present invention, preferable examples of the methyl group-containing polyorganosiloxane may include, but are not limited to, a polydimethylsiloxane.

The methyl group-containing polyorganosiloxane contains the above-described siloxane unit (D²⁰⁰ unit or D²⁰ unit), but may contain, in addition to the D²⁰⁰ unit and the D²⁰ unit, a Q unit, an M unit, and/or a T unit.

In an aspect of the present invention, specific examples of the methyl group-containing polyorganosiloxane include a polyorganosiloxane composed only of a D²⁰⁰ unit, a polyorganosiloxane containing a D²⁰⁰ unit and a Q unit, a polyorganosiloxane containing a D²⁰⁰ unit and an M unit, a polyorganosiloxane containing a D²⁰⁰ unit and a T unit, a polyorganosiloxane containing a D²⁰⁰ unit, a Q unit, and an M unit, a polyorganosiloxane containing a D²⁰⁰ unit, an M unit, and a T unit, or a polyorganosiloxane containing a D²⁰⁰ unit, a Q unit, an M unit, and a T unit.

In a preferable aspect of the present invention, specific examples of the methyl group-containing polyorganosiloxane include a polyorganosiloxane composed only of a D²⁰ unit, a polyorganosiloxane containing a D²⁰ unit and a Q unit, a polyorganosiloxane containing a D²⁰ unit and an M unit, a polyorganosiloxane containing D²⁰ units and T units, a polyorganosiloxane containing a D²⁰ unit, a Q unit, and an M unit, a polyorganosiloxane containing a D²⁰ unit, an M unit, and a T unit, or a polyorganosiloxane containing a D²⁰ unit, a Q unit, an M unit, and a T unit.

Specific examples of the methyl group-containing polyorganosiloxane include, but are not limited to, those represented by Formula (M1). 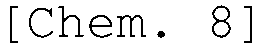 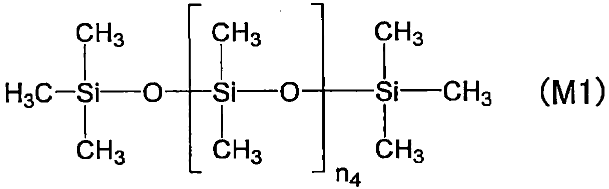 (n₄ represents the number of repeating units, and is a positive integer.)

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group may include the above-described examples, but a methyl group is preferable.

The phenyl group-containing polyorganosiloxane contains the above-described siloxane unit (D³⁰ unit), but may contain, in addition to the D³⁰ unit, a Q unit, an M unit, and/or a T unit.

In a preferable aspect of the present invention, specific examples of the phenyl group-containing polyorganosiloxane include a polyorganosiloxane composed only of a D³⁰ unit, a polyorganosiloxane containing a D³⁰ unit and a Q unit, a polyorganosiloxane containing a D³⁰ unit and an M unit, a polyorganosiloxane containing a D³⁰ unit and a T unit, a polyorganosiloxane containing a D³⁰ unit, a Q unit, and an M unit, a polyorganosiloxane containing a D³⁰ unit, an M unit, and a T unit, or a polyorganosiloxane containing a D³⁰ unit, a Q unit, an M unit, and a T unit.

Specific examples of the phenyl group-containing polyorganosiloxane include, but are not limited to, those represented by Formula (P1) or (P2). 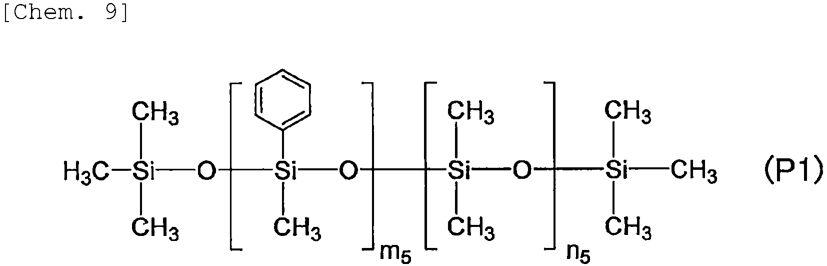 (m₅ and n₅ represent the number of respective repeating units, and are positive integers.) 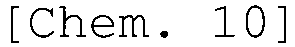 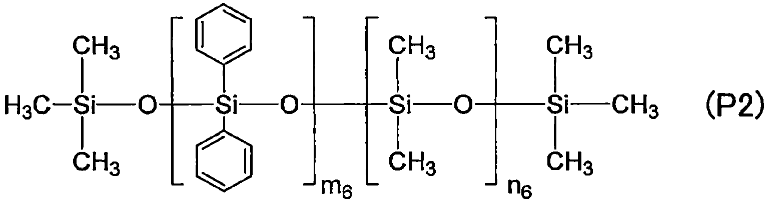 (m₆ and n₆ represent the number of respective repeating units, and are positive integers.)

The polyorganosiloxane as the release agent component (B) may be a commercially available product or a synthetic product.

Examples of commercially available products of the polyorganosiloxane include, but are not limited to, Wacker Silicone Fluid AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane (trade name: CMS-227, ECMS-327) manufactured by Gelest, Inc., epoxy group-containing polyorganosiloxane (KF-101, KF-1001, KF-1005, X-22-343) manufactured by Shin-Etsu Chemical Co., Ltd., epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc.

In one aspect, the adhesive composition used in the present invention contains a component (A) to be cured and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) and the component (B) is preferably 99.995:0.005 to 30:70, and more preferably 99.9:0.1 to 75:25 in mass ratio [(A):(B)].

That is, when the polyorganosiloxane component (A') cured by a hydrosilylation reaction is contained, the ratio of the component (A') and the component (B) is preferably 99.995:0.005 to 30:70, and more preferably 99.9:0.1 to 75:25 in mass ratio [(A'):(B)].

The viscosity of the adhesive composition used in the present invention is not particularly limited, but is usually 500 to 20,000 mPa·s, and preferably 1,000 to 10,000 mPa·s at 25°C.

An example of the adhesive composition used in the present invention can be produced by mixing the component (A) and the component (B) when used with a solvent.

The mixing order is not particularly limited, but examples of the method for easily and reproducibly producing the adhesive composition include, but are not limited to, a method in which the component (A) and the component (B) are dissolved in a solvent, and a method in which a part of the component (A) and the component (B) is dissolved in a solvent, the rest is dissolved in a solvent, and the obtained solution is mixed. Note that when the adhesive composition is prepared, the components may be heated, if appropriate, as long as the components are not decomposed or altered.

In the present invention, for the purpose of removing foreign matter, a solvent, a solution, or the like to be used may be filtered using a filter or the like during the production of the adhesive composition or after mixing all the components.

### (Laminate)

The laminate according to the present invention includes a semiconductor substrate or an electronic device layer, a support substrate, and an adhesive layer.

The laminate according to the present invention may further include a release agent layer, and in this case, includes a semiconductor substrate or an electronic device layer, a support substrate, a release agent layer, and an adhesive layer.

The adhesive layer is provided between the semiconductor substrate or the electronic device layer and the support substrate.

The laminate of the present invention is used for temporary adhesion for processing the semiconductor substrate or the electronic device layer, and can be suitably used for processing such as thinning of the semiconductor substrate or the electronic device layer.

While the semiconductor substrate is subjected to processing such as thinning, the semiconductor substrate is supported by the support substrate. On the other hand, after the processing of the semiconductor substrate, the support substrate and the semiconductor substrate are separated from each other.

In addition, while the electronic device layer is subjected to processing such as thinning, the electronic device layer is supported by the support substrate. Meanwhile, after the processing of the electronic device layer, thereafter, the support substrate and the electronic device layer are separated from each other.

Furthermore, after the semiconductor substrate or the electronic device layer is separated from the support substrate, the residue of the release agent layer or the adhesive layer remaining on the semiconductor substrate, the electronic device layer, or the support substrate can be removed by, for example, a cleaning agent composition for cleaning the semiconductor substrate and the like.

Hereinafter, a case where the laminate includes a semiconductor substrate and a case where the laminate includes an electronic device layer will be described in detail separately.

The case where the laminate includes a semiconductor substrate will be described in the following <First Embodiment>, and the case where the laminate includes an electronic device layer will be described in the following <Second Embodiment>.

### <First Embodiment>

The laminate having a semiconductor substrate is used for processing the semiconductor substrate. While the semiconductor substrate is processed, the semiconductor substrate is adhered to the support substrate. After the processing of the semiconductor substrate, the semiconductor substrate is separated from the support substrate.

### <<Semiconductor Substrate>>

The main material constituting the entire semiconductor substrate is not particularly limited as long as the material is used for this type of application, and examples thereof include silicon, silicon carbide, a compound semiconductor, and an organic resin-attached glass substrate.

The shape of the semiconductor substrate is not particularly limited, and is, for example, a disk shape. Note that the disk-shaped semiconductor substrate does not need to have a completely circular surface, and for example, the outer periphery of the semiconductor substrate may have a linear portion called an orientation flat or may have a cut called a notch.

The thickness of the disk-shaped semiconductor substrate may be appropriately determined depending on the purpose of use of the semiconductor substrate and the like, and is not particularly limited, but is, for example, 500 to 1,000 µm.

The diameter of the disk-shaped semiconductor substrate may be appropriately determined depending on the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of approximately 1 to 200 µm, a bump radius of 1 to 200 µm, and a bump pitch of 1 to 500 µm.

Examples of the material of the bump include low melting point solder, high melting point solder, tin, indium, gold, silver, and copper. The bump may be composed of only a single component or may be composed of a plurality of components. More specific examples thereof include alloy plate mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 µm.

### <<Support Substrate>>

The support substrate is not particularly limited as long as the support substrate is a member capable of supporting the semiconductor substrate when the semiconductor substrate is processed. Examples thereof include a glass support substrate and a silicon support substrate.

The shape of the support substrate is not particularly limited, and examples thereof include a disk shape. Note that the disk-shaped support substrate does not need to have a completely circular surface shape, and for example, the outer periphery of the support substrate may have a straight portion called an orientation flat or may have a cut called a notch.

The thickness of the disk-shaped support substrate may be appropriately determined depending on the size of the semiconductor substrate and the like, and is not particularly limited, but is, for example, 500 to 1,000 µm.

The diameter of the disk-shaped support substrate may be appropriately determined depending on the size of the semiconductor substrate and the like, and is not particularly limited, but is, for example, 100 to 1,000 mm.

An example of the support substrate is a glass wafer having a diameter of about 300 mm and a thickness of about 700 µm.

Note that when release is performed by light irradiation in the laminate, for example, a substrate that is light-transmissive with respect to light to be used is used as the support substrate.

### <<Adhesive Layer>>

The adhesive layer is provided between the support substrate and the semiconductor substrate.

The adhesive layer is in contact with, for example, the semiconductor substrate. The adhesive layer may be in contact with, for example, the support substrate.

The adhesive layer is an adhesive layer formed of an adhesive composition.

The thickness of the adhesive layer included in the laminate of the present invention is not particularly limited, but is usually 5 to 500 µm, and is preferably 10 µm or more, more preferably 20 µm or more, and still more preferably 30 µm or more from the viewpoint of maintaining the film strength, and is preferably 200 µm or less, more preferably 150 µm or less, still more preferably 120 µm or less, and further preferably 100 µm or less from the viewpoint of avoiding nonuniformity caused by a thick film.

The method for forming the adhesive layer from the adhesive composition will be described in detail in the description of <<Method for Producing One Example of Laminate in First Embodiment>> described below.

### <<Release Agent Layer>>

The laminate may have a release agent layer.

In the laminate having the release agent layer, the semiconductor substrate and the support substrate are separated by, for example, irradiating the release agent layer with light.

The release agent layer is a layer formed of a release agent composition.

### <<<Release Agent Composition>>>

The release agent composition contains, for example, at least an organic resin or a polynuclear phenol derivative, and further contains other components as necessary.

The organic resin is preferably one that can exhibit a suitable releasing ability. When the semiconductor substrate and the support substrate are separated by irradiating the release agent layer with light, the organic resin absorbs light and suitably undergoes a deterioration that is necessary to improve releasing ability, for example, decomposition.

In the laminate having the release agent layer formed of the release agent composition, the release agent layer can be released without applying an excessive load for release thereto by, for example, irradiating the release agent layer with a laser.

The release agent layer provided in the laminate has an adhesive strength that becomes lower by, for example, laser irradiation than before irradiation. That is, in the laminate, for example, while the semiconductor substrate is subjected to processing such as thinning, the semiconductor substrate is suitably supported on the support substrate that transmits the laser via the adhesive layer and the release agent layer, and after the processing is completed, when the laminate is irradiated with the laser from the support substrate side, the laser that has transmitted through the support substrate is absorbed by the release agent layer, alteration (for example, separation) occurs in the release agent layer at the interface between the release agent layer and the adhesive layer, at the interface between the release agent layer and the support substrate, or in the release agent layer, and as a result, suitable release (separation) can be achieved without applying an excessive load for release thereto.

Examples of the organic resin include novolac resin bodies and the like. Details thereof will be described later.

As a preferable embodiment, the release agent composition contains at least a novolac resin, and further contains other components such as a crosslinking agent, an acid generating agent, an acid, a surfactant, and a solvent as necessary.

As another preferable embodiment, the release agent composition contains at least a polynuclear phenol derivative and a crosslinking agent, and further contains other components such as an acid generating agent, an acid, a surfactant, and a solvent as necessary.

As still another preferable embodiment, the release agent composition contains at least an organic resin and a branched polysilane, and further contains other components such as a crosslinking agent, an acid generating agent, an acid, a surfactant, and a solvent as necessary.

### <<<<Novolac Resin>>>>

The novolac resin is, for example, a resin obtained by condensation reaction of at least one of a phenolic compound, a carbazole compound, and an aromatic amine compound with at least one of an aldehyde compound, a ketone compound, and a divinyl compound under an acid catalyst.

Examples of the phenolic compound include phenols, naphthols, anthrols, hydroxypyrenes, and the like. Examples of the phenols include phenol, cresol, xylenol, resorcinol, bisphenol A, p-tert-butylphenol, p-octylphenol, 9,9-bis(4-hydroxyphenyl)fluorene, and 1,1,2,2-tetrakis(4-hydroxyphenyl)ethane. Examples of the naphthols include 1-naphthol, 2-naphthol, 1,5-dihydroxynaphthalene, 2,7-dihydroxynaphthalene, and 9,9-bis(6-hydroxynaphthyl)fluorene. Examples of the anthrols include 9-anthrol. Examples of the hydroxypyrenes include 1-hydroxypyrene and 2-hydroxypyrene.

Examples of the carbazole compound include carbazole, 1,3,6,8-tetranitrocarbazole, 3,6-diaminocarbazole, 3,6-dibromo-9 ethylcarbazole, 3,6-dibromo-9-phenylcarbazole, 3,6-dibromocarbazole, 3,6-dichlorocarbazole, 3-amino-9-ethylcarbazole, 3-bromo-9-ethylcarbazole, 4,4'bis(9H-carbazole-9-yl)biphenyl, 4-glycidylcarbazole, 4-hydroxycarbazole, 9-(1H-benzotriazole-1-ylmethyl)-9H-carbazole, 9-acetyl-3,6-diiodocarbazole, 9-benzoylcarbazole, 9-benzoylcarbazole-6-dicarboxyaldehyde, 9-benzylcarbazole-3-carboxyaldehyde, 9-methylcarbazole, 9-phenylcarbazole, 9-vinylcarbazole, carbazole potassium, carbazole-N-carbonyl chloride, N-ethylcarbazole-3-carboxaldehyde, and N-((9-ethylcarbazole-3-yl)methylene)-2-methyl-1-indolinylamine.

Examples of the aromatic amine compound include diphenylamine and N-phenyl-1-naphthylamine.

These solvents can be used alone or in combination of two or more thereof.

These may have a substituent. For example, these may have a substituent in the aromatic ring.

Examples of the aldehyde compound include saturated aliphatic aldehydes such as formaldehyde, paraformaldehyde, acetaldehyde, propylaldehyde, butyraldehyde, isobutyraldehyde, valeraldehyde, caproaldehyde, 2-methylbutyraldehyde, hexylaldehyde, undecane aldehyde, 7-methoxy-3,7-dimethyloctylaldehyde, cyclohexanaldehyde, 3-methyl-2-butyraldehyde, glyoxal, malonaldehyde, succinaldehyde, glutaraldehyde, and adipine aldehyde; unsaturated aliphatic aldehydes such as acrolein and methacrolein; heterocyclic aldehydes such as furfural and pyridinaldehyde; and aromatic aldehydes such as benzaldehyde, naphthylaldehyde, anthraldehyde, phenanthrylaldehyde, salicylaldehyde, phenylacetaldehyde, 3-phenylpropionaldehyde, tolylaldehyde, (N,N-dimethylamino)benzaldehyde, and acetoxybenzaldehyde. Among them, aromatic aldehydes are preferable.

Examples of the ketone compound include diaryl ketone compounds such as diphenyl ketone, phenyl naphthyl ketone, dinaphthyl ketone, phenyl tolyl ketone, and ditolyl ketone.

Examples of the divinyl compound include divinylbenzene, dicyclopentadiene, tetrahydroindene, 4-vinylcyclohexene, 5-vinylnoborna-2-ene, divinylpyrene, limonene, and 5-vinylnorbornadiene.

These solvents can be used alone or in combination of two or more thereof.

The novolac resin is, for example, a novolac resin that absorbs light radiated from the support substrate side and alters. The alteration is, for example, photolysis.

The novolac resin contains, for example, at least one of a structural unit represented by the following Formula (C1-1), a structural unit represented by the following Formula (C1-2), and a structural unit represented by the following Formula (C1-3).

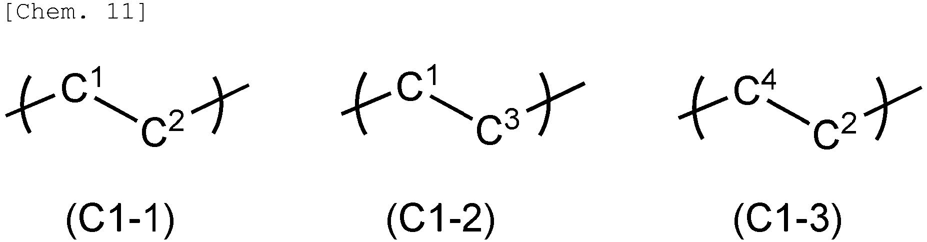

In the formula, C¹ represents a group derived from an aromatic compound containing a nitrogen atom, C² represents a group containing a tertiary carbon atom having, as a side chain, at least one selected from the group consisting of secondary carbon atoms, quaternary carbon atoms, and aromatic rings, C³ represents a group derived from an aliphatic polycyclic compound, and C⁴ represents a group derived from phenol, a group derived from bisphenol, a group derived from naphthol, a group derived from biphenyl, or a group derived from biphenol.

That is, the novolac resin contains, for example, one or more types of the following structural units.
· Structural unit having a bond between a group derived from an aromatic compound containing a nitrogen atom and a group containing a tertiary carbon atom having, as a side chain, at least one selected from the group consisting of a secondary carbon atom, a quaternary carbon atom, and an aromatic ring (Formula (C1-1))
· Structural unit having a bond between a group derived from an aromatic compound containing a nitrogen atom and a group derived from aliphatic polycyclic compound (Formula (C1-2))
· A structural unit having a bond between a group derived from phenol, a group derived from bisphenol, a group derived from naphthol, a group derived from biphenyl, or a group derived from biphenol, and a group containing a tertiary carbon atom having, as a side chain, at least one selected from the group consisting of a secondary carbon atom, a quaternary carbon atom, and an aromatic ring ((Formula (C1-3))

In a preferable aspect, the novolac resin contains any one or both of a structural unit having a bond between a group derived from an aromatic compound containing a nitrogen atom and a group containing a tertiary carbon atom having, as a side chain, at least one selected from the group consisting of a secondary carbon atom, a quaternary carbon atom (Formula (C1-1)), and an aromatic ring, and a structural unit having a bond between a group derived from an aromatic compound containing a nitrogen atom and a group derived from an aliphatic polycyclic compound (Formula (C1-2)).

The group derived from the aromatic compound containing the nitrogen atom of C¹ can be, for example, a group derived from carbazole, a group derived from N-phenyl-1-naphthylamine, a group derived from N-phenyl-2-naphthylamine, or the like, but is not limited thereto.

The group containing a tertiary carbon atom having, as a side chain, at least one selected from the group consisting of a secondary carbon atom, a quaternary carbon atom, and an aromatic ring of C² can be, for example, a group derived from 1-naphthaldehyde, a group derived from 1-pyrenecarboxaldehyde, a group derived from 4-(trifluoromethyl)benzaldehyde, a group derived from acetaldehyde, or the like, but is not limited thereto.

The group derived from the aliphatic polycyclic compound of C³ can be, but is not limited to, a group derived from dicyclopentadiene.

C⁴ represents a group derived from phenol, a group derived from bisphenol, a group derived from naphthol, a group derived from biphenyl, or a group derived from biphenol.

In a preferable aspect, the novolac resin contains, for example, a structural unit represented by the following Formula (C1-1-1) as the structural unit represented by Formula (C1-1).

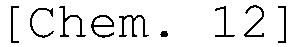

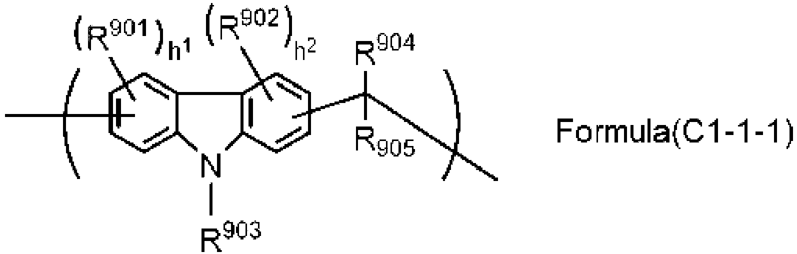

In Formula (C1-1-1), R⁹⁰¹ and R⁹⁰² represent a substituent substituted with a ring, and each independently represent a halogen atom, a nitro group, a cyano group, an amino group, a hydroxy group, a carboxy group, an optionally substituted alkyl group, an optionally substituted alkenyl group, or an optionally substituted aryl group.

R⁹⁰³ represents a hydrogen atom, an optionally substituted alkyl group, an optionally substituted alkenyl group, or an optionally substituted aryl group.

R⁹⁰⁴ represents a hydrogen atom, an optionally substituted aryl group, or an optionally substituted heteroaryl group.

R⁹⁰⁵ represents an optionally substituted alkyl group, an optionally substituted aryl group, or an optionally substituted heteroaryl group.

The group of R⁹⁰⁴ and the group of R⁹⁰⁵ may be bonded to each other to form a divalent group.

Examples of the substituent of the alkyl group and the alkenyl group include a halogen atom, a nitro group, a cyano group, an amino group, a hydroxy group, a carboxy group, an aryl group, and a heteroaryl group.

Examples of the substituent of the aryl group and the heteroaryl group include a halogen atom, a nitro group, a cyano group, an amino group, a hydroxy group, a carboxy group, an alkyl group, and an alkenyl group.

h¹ and h² each independently represent an integer of 0 to 3.

The number of carbon atoms of the optionally substituted alkyl group and the optionally substituted alkenyl group is usually 40 or less, and from the viewpoint of solubility, the number of carbon atoms is preferably 30 or less, and more preferably 20 or less.

The number of carbon atoms of the optionally substituted aryl group and heteroaryl group is usually 40 or less, and from the viewpoint of solubility, preferably 30 or less, and more preferably 20 or less.

Examples of the halogen atom include fluorine atom, chlorine atom, bromine atom, and iodine atom.

Specific examples of the optionally substituted alkyl group include, but are not limited to, a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

Specific examples of the optionally substituted alkenyl group include, but are not limited to, an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4 pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-tertiary butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group.

Specific examples of the optionally substituted aryl group include, but are not limited to, a phenyl group, a 2-methylphenyl group, a 3-methylphenyl group, a 4-methylphenyl group, a 2-chlorophenyl group, a 3-chlorophenyl group, a 4-chlorophenyl group, a 2-fluorophenyl group, a 3-fluorophenyl group, a 4-fluorophenyl group, a 4-methoxyphenyl group, a 4-ethoxyphenyl group, a 4-nitrophenyl group, a 4-cyanophenyl group, a 1-naphthyl group, a 2-naphthyl group, a biphenyl-4-yl group, a biphenyl-3-yl group, a biphenyl-2-yl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Specific examples of the optionally substituted heteroaryl group include, but are not limited to, a 2-thienyl group, a 3-thienyl group, a 2-furanyl group, a 3-furanyl group, a 2-oxazolyl group, a 4-oxazolyl group, a 5-oxazolyl group, a 3-isoxazolyl group, a 4-isoxazolyl group, a 5-isoxazolyl group, a 2-thiazolyl group, a 4-thiazolyl group, a 5-thiazolyl group, a 3-isothiazolyl group, a 4-isothiazolyl group, and a 5-isothiazolyl group.

Hereinafter, specific examples of the structural unit represented by Formula (C1-1-1) will be given, but the structural unit is not limited thereto.

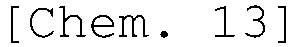

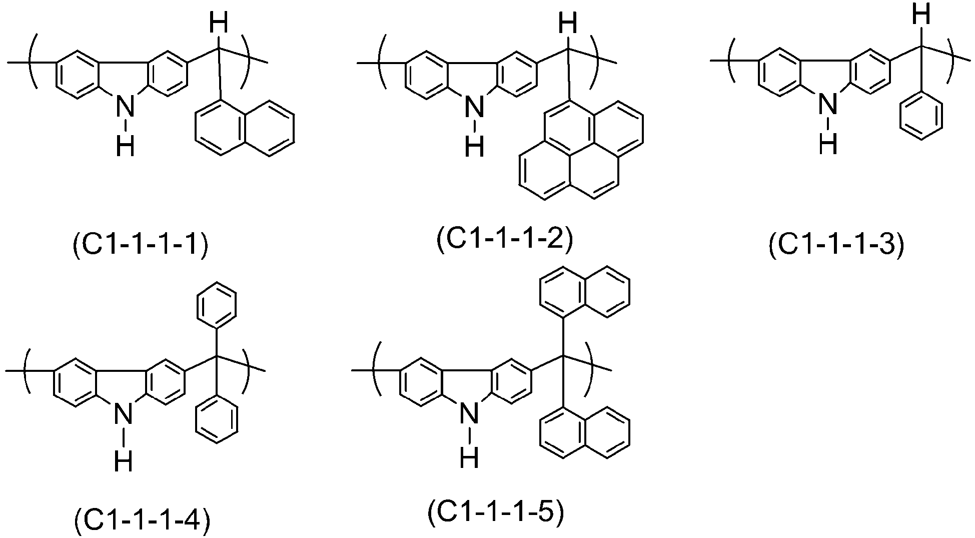

In a preferable aspect, the novolac resin contains, for example, a structural unit represented by the following Formula (C1-1-2) as the structural unit represented by Formula (C1-1).

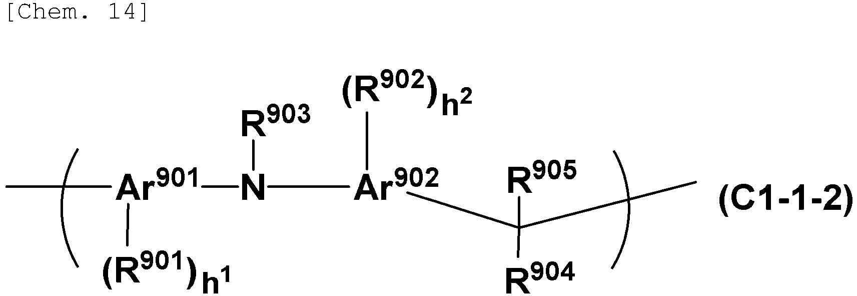

In Formula (C1-1-2), Ar⁹⁰¹ and Ar⁹⁰² each independently represent an aromatic ring, and R⁹⁰¹ to R⁹⁰⁵ and h¹ and h² represent the same meaning as described above.

Hereinafter, specific examples of the structural unit represented by Formula (C1-1-2) will be given, but the structural unit is not limited thereto.

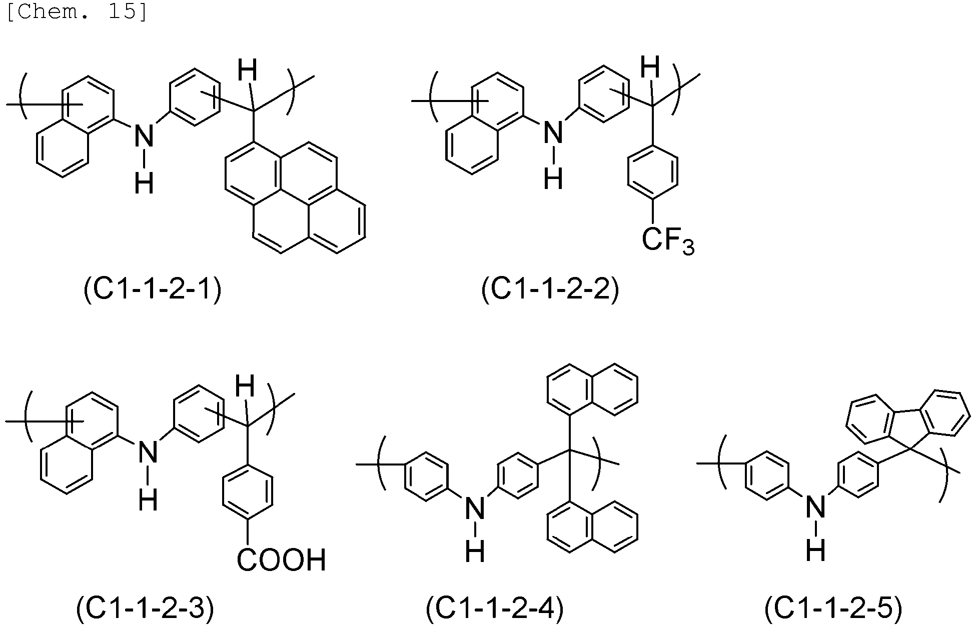

In a preferred aspect, the novolac resin contains, for example, a structural unit represented by the following Formula (C1-2-1) or (C1-2-2) as the structural unit represented by Formula (C1-2).

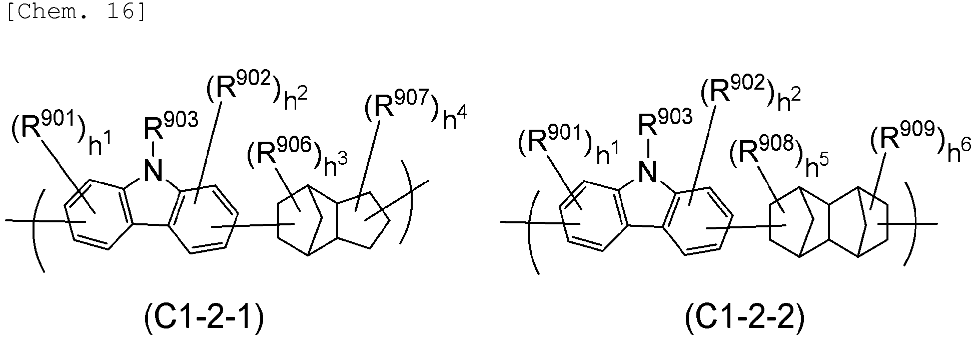

In the above formula, R⁹⁰⁶ to R⁹⁰⁹ are substituents bonded to a ring, and each independently represent a halogen atom, a nitro group, a cyano group, an amino group, a hydroxy group, a carboxy group, an optionally substituted alkyl group, an optionally substituted alkenyl group, or an optionally substituted aryl group. Specific examples and suitable numbers of carbon atoms of the halogen atom, the optionally substituted alkyl group, the optionally substituted alkenyl group, and the optionally substituted aryl group are the same as those described above, h³ to h⁶ each independently represent an integer of 0 to 3, and R⁹⁰¹ to R⁹⁰³, and h¹, and h² each represent the same meaning as described above.

Hereinafter, specific examples of the structural units represented by Formulas (C1-2-1) and (C1-2-2) will be given, but the structural units are not limited thereto.

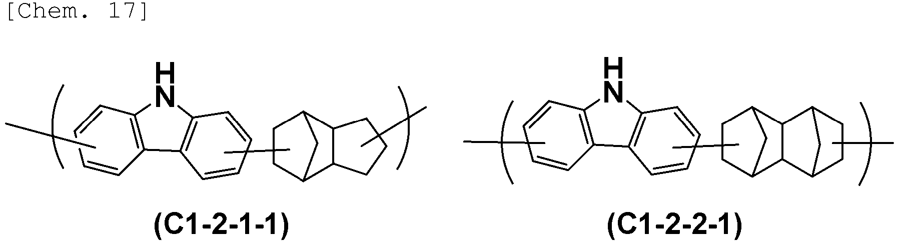

Hereinafter, specific examples of the structural unit represented by Formula (C1-3) will be given, but the structural unit is not limited thereto.

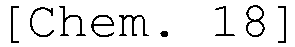

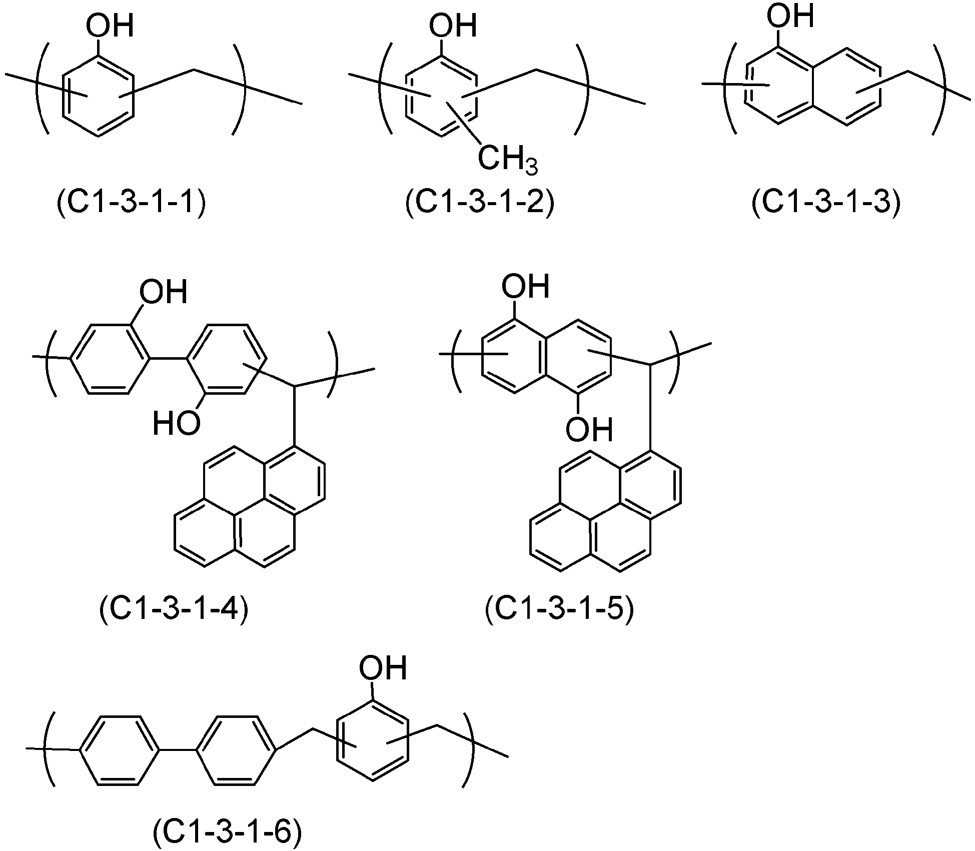

As described above, the novolac resin is, for example, a resin obtained by condensation reaction of at least one of a phenolic compound, a carbazole compound, and an aromatic amine compound with at least one of an aldehyde compound, a ketone compound, and a divinyl compound under an acid catalyst.

In this condensation reaction, for example, an aldehyde compound or a ketone compound is usually used in a ratio of 0.1 to 10 equivalents to 1 equivalent of a benzene ring constituting a ring of a carbazole compound.

In the condensation reaction, an acid catalyst is usually used.

Examples of the acid catalyst include, but are not limited to, mineral acids such as sulfuric acid, phosphoric acid, and perchloric acid, organic sulfonic acids such as p-toluenesulfonic acid and p-toluenesulfonic acid monohydrate, and carboxylic acids such as formic acid and oxalic acid.

The amount of the acid catalyst is appropriately determined depending on the type of the acid to be used and the like, and thus cannot be generally defined, but is usually appropriately determined from the range of 0.001 to 10,000 parts by mass with respect to 100 parts by mass of the carbazole compound.

When either the raw material compound or the acid catalyst to be used is a liquid, the condensation reaction can be performed without using a solvent in some cases, but is usually performed using a solvent.

Such a solvent is not particularly limited as long as the reaction is not inhibited, but typically includes ether compounds such as cyclic ether ester compounds (for example, tetrahydrofuran and dioxane).

The reaction temperature is usually appropriately determined from the range of 40°C to 200°C, and the reaction time cannot be generally determined because the reaction time varies depending on the reaction temperature, but is usually appropriately determined from the range of 30 minutes to 50 hours.

After completion of the reaction, if necessary, purification and isolation are performed according to a conventional method, and the obtained novolac resin is used for preparation of a release agent composition.

Those skilled in the art can determine the production conditions of the novolac resin without an excessive burden based on the above description and the common general technical knowledge, and therefore can produce the novolac resin.

The weight average molecular weight of the organic resin such as the novolac resin is usually 500 to 200,000, and is preferably 100,000 or less, more preferably 50,000 or less, still more preferably 10,000 or less, further preferably 5,000 or less, and even more preferably 3,000 or less from the viewpoint of securing solubility in a solvent, the viewpoint of favorably mixing with a branched polysilane when the organic resin has been made into a film and obtaining a uniform film and the like, and is preferably 600 or more, more preferably 700 or more, still more preferably 800 or more, further preferably 900 or more, and even more preferably 1,000 or more from the viewpoint of improving the strength of the film and the like.

In the present invention, the weight average molecular weight, the number average molecular weight, and the dispersibility of the organic resin such as the novolac resin, which is a polymer, can be measured, for example, using a GPC device (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (elution solvent), at a flow rate of 0.35 mL/min, and using polystyrene (manufactured by Sigma-Aldrich) as a standard sample.

As the organic resin contained in the release agent composition, a novolac resin is preferable, and the release agent composition thus preferably contains a novolac resin alone as the organic resin, but may contain other polymers together with the novolac resin for the purpose of adjusting film physical properties and the like.

Examples of such other polymers include polyacrylic acid ester compounds, polymethacrylic acid ester compounds, polyacrylamide compounds, polymethacrylamide compounds, polyvinyl compounds, polystyrene compounds, polymaleimide compounds, polymaleic anhydrides, and polyacrylonitrile compounds.

The content of the novolac resin in the release agent composition is not particularly limited, but is preferably 70 mass% or more with respect to the total amount of the polymer contained in the release agent composition.

The content of the novolac resin in the release agent composition is not particularly limited, but is preferably 50 to 100 mass% with respect to the film constituent component. In the present invention, the film constituent component means a component other than the solvent contained in the composition.

### <<<<Polynuclear Phenol Derivative>>>>

The polynuclear phenol derivative is represented by, for example, the following Formula (P). 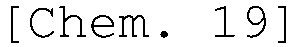 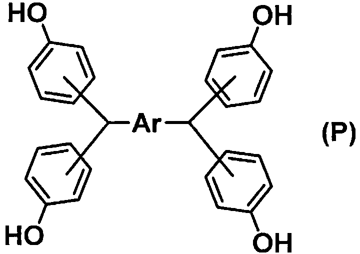 In Formula (P), Ar represents an arylene group, and the number of carbon atoms therein is not particularly limited, but is usually 6 to 60, preferably 30 or less, more preferably 20 or less, still more preferably 18 or less, and further preferably 12 or less from the viewpoint of preparing a release agent composition having excellent uniformity and obtaining a release agent layer having higher flatness with good reproducibility.

Specific examples of such an arylene group include, but are not limited to, 1,2-phenylene, 1,3-phenylene, and 1,4-phenylene; groups derived by removing two hydrogen atoms on an aromatic ring of a fused ring aromatic hydrocarbon compound such as 1,5-naphthalenediyl, 1,8-naphthalenediyl, 2,6-naphthalenediyl, 2,7-naphthalenediyl, 1,2-anthracenediyl, 1,3-anthracenediyl, 1,4-anthracenediyl, 1,5-anthracenediyl, 1,6-anthracenediyl, 1,7-anthracenediyl, 1,8-anthracenediyl, 2,3-anthracenediyl, 2,6-anthracenediyl, 2,7-anthracenediyl, 2,9-anthracenediyl, 2,10-anthracenediyl, and a 9,10-anthracenediyl group; and groups derived by removing two hydrogen atoms on an aromatic ring of a ring-linked aromatic hydrocarbon compound such as a biphenyl-4,4'-diyl group or a paraterphenyl-4,4"-diyl group.

The polynuclear phenol derivative represented by Formula (P) is preferably a polynuclear phenol derivative represented by Formula (P-1), more preferably a polynuclear phenol derivative represented by Formula (P-1-1), and still more preferably a polynuclear phenol derivative represented by Formula (P1) from the viewpoint of obtaining, with good reproducibility, a laminate in which the release agent layer exhibits good releasability and the support substrate can be satisfactorily separated,

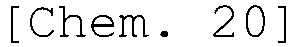

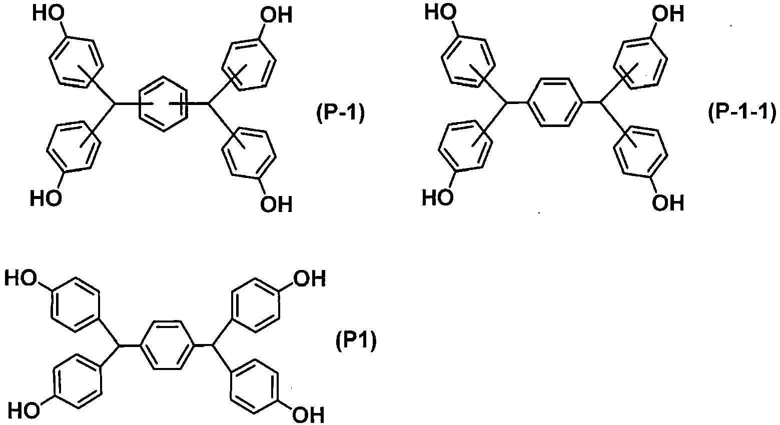

The content of the polynuclear phenol derivative in the release agent composition is not particularly limited, but is preferably 50 to 100 mass% with respect to the film constituent component.

### <<<<Branched Polysilane>>>>

The release agent composition may contain a branched polysilane.

The branched polysilane has a Si-Si bond and a branched structure. When the branched polysilane is contained in the release agent composition, the release agent layer formed of a film to be obtained cannot be suitably removed with any of an organic solvent, an acid, and a chemical solution used in the production of a semiconductor element (an alkali developer, hydrogen peroxide water, or the like), but can be suitably removed with a cleaning agent composition, and as a result, the residue of the release agent layer on the substrate can be suitably removed by separating the semiconductor substrate and the support substrate of the laminate from each other and then cleaning each substrate with the cleaning agent composition. Although the reason therefor is not clear, it is presumed that depending on the type of the terminal group (terminal substituent (atom)) of the polysilane, the polysilane can react with the organic resin and crosslink, the branched polysilane has more terminal groups (terminal substituents (atoms)) than linear polysilanes, and it is thus considered that the branched polysilane has more crosslinking points than linear polysilanes, and both a property of not being suitably removed with an organic solvent, an acid, and a chemical solution used in the production of a semiconductor element (an alkali developer, hydrogen peroxide water, or the like) and a property of being suitably removed with a cleaning agent composition can be achieved by appropriate and suitable curing through such more crosslinking points in the branched polysilane.

The branched polysilane preferably includes a structural unit represented by Formula (B).

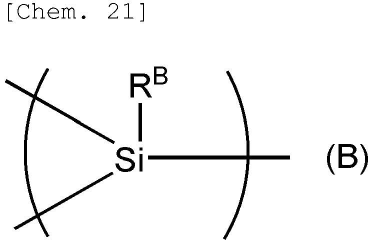

In Formula (B), R^{B} represents a hydrogen atom, a hydroxy group, a silyl group, or an organic group, specific examples of such an organic group include hydrocarbon groups (an optionally substituted alkyl group, an optionally substituted alkenyl group, an optionally substituted aryl group, and an optionally substituted aralkyl group) and ether groups corresponding to these hydrocarbon groups (an optionally substituted alkoxy group, an optionally substituted aryloxy group, an optionally substituted aralkyloxy group, and the like), and the organic group is usually a hydrocarbon group such as an alkyl group, an alkenyl group, an aryl group, or an aralkyl group in many cases. In addition, a hydrogen atom, a hydroxy group, an alkoxy group, a silyl group, or the like is often substituted into a terminal.

The optionally substituted alkyl group may be linear, branched, or cyclic.

Specific examples of the optionally substituted linear or branched alkyl group include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is ordinarily 1 to 14, preferably 1 to 10, and more preferably 1 to 6.

Specific examples of the optionally substituted cyclic alkyl group include, but are not limited to, a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is ordinarily 3 to 14, preferably 4 to 10, and more preferably 5 to 6.

The alkenyl group may be linear, branched, or cyclic.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, and more preferably 1 to 6.

Specific examples of the optionally substituted cyclic alkenyl group include, but are not limited to, cyclopentenyl and cyclohexenyl, and the number of carbon atoms thereof is usually 4 to 14, preferably 5 to 10, and more preferably 5 to 6.

Specific examples of the optionally substituted aryl group include, but are not limited to, a phenyl group, a 4-methylphenyl group, a 3-methylphenyl group, a 2-methylphenyl group, a 3,5-dimethylphenyl group, a 1-naphthyl group, and a 2-naphthyl group, and the number of carbon atoms therein is usually 6 to 20, preferably 6 to 14, and more preferably 6 to 12.

Specific examples of the optionally substituted aralkyl group include, but are not limited to, a benzyl group, a phenethyl group, and a phenylpropyl group. The optionally substituted aralkyl group is preferably a group in which one hydrogen atom of an alkyl group having 1 to 4 carbon atoms has been substituted with an aryl group having 6 to 20 carbon atoms.

The optionally substituted alkoxy group may be linear, branched, or cyclic in an alkyl moiety thereof.

Specific examples of the optionally substituted linear or branched alkoxy group include, but are not limited to, a methoxy group, an ethoxy group, a propoxy group, an isopropoxy group, a butoxy group, a t-butoxy group, and a pentyloxy group and the number of carbon atoms therein is usually 1 to 14, preferably 1 to 10, and more preferably 1 to 6.

Specific examples of the optionally substituted cyclic alkoxy group include, but are not limited to, cyclopentenyl and cyclohexenyl, and the number of carbon atoms thereof is ordinarily 3 to 14, preferably 4 to 10, and more preferably 5 to 6.

Specific examples of the optionally substituted aryloxy group include, but are not limited to, phenoxy, 1-naphthyloxy, and 2-naphthyloxy, and the number of carbon atoms therein is usually 6 to 20, preferably 6 to 14, and more preferably 6 to 10.

Specific examples of the optionally substituted aralkyloxy group include, but are not limited to, benzyloxy, phenethyloxy, and phenylpropyloxy. The optionally substituted aralkyloxy group is preferably a group in which one hydrogen atom of an alkyloxy group having 1 to 4 carbon atoms has been substituted with an aryl group having 6 to 20 carbon atoms.

Specific examples of the silyl group include, but are not limited to, a silyl group, a disilanyl group, and a trisilanyl group, and the number of silicon atoms therein is usually 1 to 10 and preferably 1 to 6.

When R^{B} is the organic group or the silyl group, at least one of the hydrogen atoms may be substituted with a substituent. Specific examples of such a substituent include a hydroxy group, an alkyl group, an aryl group, and an alkoxy group.

R^{B} is preferably an alkyl group or an aryl group, more preferably an aryl group, still more preferably a phenyl group, a 1-naphthyl group, or a 2-naphthyl group, and further preferably a phenyl group from the viewpoint of suppressing unintentional release when the laminate is brought into contact with any of an organic solvent, an acid, and a chemical solution used in the production of a semiconductor element (an alkali developer, hydrogen peroxide water, or the like), the viewpoint of suitably removing the residue of the release agent layer on the substrate when the semiconductor substrate and the support substrate of the laminate have been separated from each other and each substrate has then been cleaned with a cleaning agent composition, and the like.

The branched polysilane may contain a structural unit represented by the following Formula (S) or a structural unit represented by the following Formula (N) together with the structural unit represented by Formula (B), and the content of the structural unit represented by Formula (B) in the branched polysilane is usually 50 mol% or more, preferably 60 mol% or more, more preferably 70 mol% or more, still more preferably 80 mol% or more, further preferably 90% or more, and even more preferably 95 mol% or more in all of the structural units from the viewpoint of suppressing unintentional release when the laminate is brought into contact with any of an organic solvent, an acid, and a chemical solution used in the production of a semiconductor element (an alkali developer, hydrogen peroxide water, or the like), the viewpoint of suitably removing the residue of the release agent layer on the substrate when the semiconductor substrate and the support substrate of the laminate have been separated from each other and each substrate has then been cleaned with a cleaning agent composition, and the like. 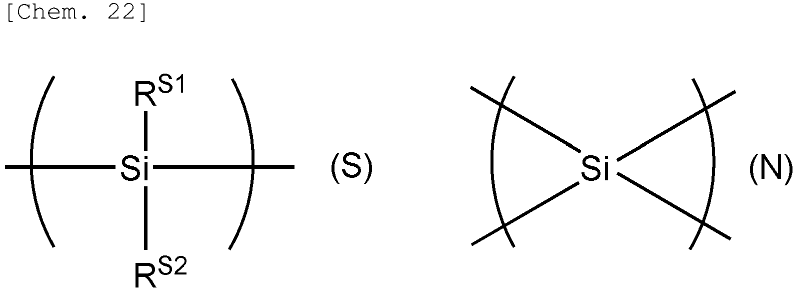 (R^{S1} and R^{S2} represent the same meaning as R^{B}.)

The terminal group (terminal substituent (atom)) of the branched polysilane may be usually a hydrogen atom, a hydroxy group, a halogen atom (a chlorine atom or the like), an alkyl group, an aryl group, an alkoxy group, a silyl group, or the like. Among them, the terminal group is often a hydroxy group, a methyl group, or a phenyl group, and among them, a methyl group is preferable, and the terminal group may be a trimethylsilyl group.

In an aspect, the average degree of polymerization of the branched polysilane is usually 2 to 100, preferably 3 to 80, more preferably 5 to 50, and still more preferably 10 to 30 in terms of silicon atoms (that is, the average number of silicon atoms per molecule).

In an aspect, the upper limit value of the weight average molecular weight of the branched polysilane is usually 30,000, preferably 20,000, more preferably 10,000, still more preferably 5,000, further preferably 2,000, and even more preferably 1,500, and the lower limit value thereof is usually 50, preferably 100, more preferably 150, still more preferably 200, further preferably 300, and even more preferably 500.

The average degree of polymerization and weight average molecular weight of the branched polysilane can be measured using, for example, a GPC device (EcoSEC, HLC-8220GPC manufactured by Tosoh Corporation) and a GPC column (Shodex KF-803L, KF-802, and KF-801 manufactured by Showa Denko K.K., used in this order), at a column temperature of 40°C, using tetrahydrofuran as an eluent (elution solvent), at a flow rate of 1.00 mL/min, and using polystyrene (manufactured by Sigma-Aldrich) as a standard sample.

When the degree of polymerization and weight average molecular weight of the branched polysilane to be used are too small, there is a possibility that the branched polysilane may vaporize by heating when a film that is the release agent layer is formed or when the laminate including the obtained release agent layer is processed, or a disadvantage due to a poor strength of the film may be generated, and when the degree of polymerization and molecular weight of the branched polysilane to be used are too large, there is a possibility that sufficient solubility cannot be secured depending on the type of a solvent to be used for the preparation of the release agent composition, precipitation may occur in the composition, or mixing with a resin may become insufficient, which makes it impossible to obtain a highly uniform film with high reproducibility.

Therefore, it is desirable that the degree of polymerization and weight average molecular weight of the branched polysilane satisfy the above-described ranges from the viewpoint of obtaining a laminate including a release agent layer contributing to suitable production of a semiconductor element with better reproducibility.

The 5% weight loss temperature of the branched polysilane is usually 300°C or higher, preferably 350°C or higher, more preferably 365°C or higher, still more preferably 380°C or higher, further preferably 395°C or higher, and even more preferably 400°C or higher from the viewpoint of reproducibly obtaining a release agent layer excellent in heat resistance.

The 5% weight loss temperature of the branched polysilane can be measured by, for example, raising the temperature from normal temperature (25°C) to 400°C at 10°C/minute under an air using 2010SR manufactured by

### NETZSCH.

When the semiconductor substrate and the support substrate of the laminate are separated from each other, and each substrate is then cleaned with a cleaning agent composition, the branched polysilane is preferably dissolved in any of an ether compound such as tetrahydrofuran, an aromatic compound such as toluene, a glycol ether ester compound such as propylene glycol monomethyl ether acetate, a ketone compound such as cyclohexanone or methyl ethyl ketone, and a glycol ether compound such as propylene glycol monomethyl ether from the viewpoint of suitably removing the residue of the release agent layer on the substrate, the viewpoint of preparing a release agent composition having excellent uniformity with good reproducibility, and the like. Note that dissolution in this case means a case where dissolution within 1 hour can be visually confirmed when an attempt is made for dissolution using a shaker at normal temperature (25°C) such that a 10 mass% solution is produced.

The branched polysilane may be either solid or liquid at normal temperature.

The branched polysilane can also be produced with reference to a known method described in, for example, Japanese Patent Application Laid-Open No. 2011-208054, Japanese Patent Application Laid-Open No. 2007-106894, Japanese Patent Application Laid-Open No. 2007-145879, and WO2005/113648 or can be procured as a commercially available product. Specific examples of the commercially available product include, but are not limited to, silicon materials Polysilane OGSOL SI-20-10 and SI-20-14 manufactured by Osaka Gas Chemicals Co., Ltd.

Suitable examples of the branched polysilane include, but are not limited to, the following. 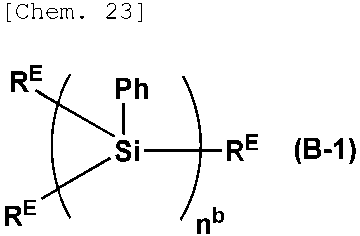 (Ph represents a phenyl group, R^{E}'s each independently represent a terminal substituent and represents an atom or a group, and n^{b} indicates the number of repeating units.)

The content of the branched polysilane in the release agent composition is usually 10 to 90 mass% with respect to the film constituent component, but is preferably 15 to 80 mass%, more preferably 20 to 70 mass%, still more preferably 25 to 60 mass%, and further preferably 30 to 50 mass% from the viewpoint of achieving with good reproducibility a film that cannot be suitably removed with an organic solvent, an acid, and a chemical solution used in the production of a semiconductor element (an alkali developer, hydrogen peroxide water, or the like) but can be suitably removed with a cleaning agent composition.

### <<<<Crosslinking Agent>>>>

The release agent composition may include a crosslinking agent.

The crosslinking agent may cause a crosslinking reaction by self-condensation, but when crosslinkable substituents are present in the novolac resin, the crosslinking agent can cause a crosslinking reaction with these crosslinkable substituents.

Specific examples of the crosslinking agent are not particularly limited, but typically include phenol-based crosslinking agents, melamine-based crosslinking agents, urea-based crosslinking agents, thiourea-based crosslinking agents, and the like, each of which has a crosslinking-forming group in the molecule, such as an alkoxymethyl group (for example, a hydroxymethyl group, a methoxymethyl group, or a butoxymethyl group), and these may be low molecular weight compounds or high molecular weight compounds.

The crosslinking agent contained in the release agent composition usually has two or more crosslinking-forming groups, but from the viewpoint of achieving more suitable curing with good reproducibility, the number of crosslinking groups contained in a compound as the crosslinking agent is preferably 2 to 10, and more preferably 2 to 6.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, a phenol-based crosslinking agent.

The phenol-based crosslinking agent having a crosslinking-forming group is a compound having a crosslinking-forming group bonded to an aromatic ring and having at least one of a phenolic hydroxy group and an alkoxy group derived from a phenolic hydroxy group, and examples of such an alkoxy group derived from a phenolic hydroxy group include, but are not limited to, a methoxy group and a butoxy group.

Each of the aromatic ring to which the crosslinking-forming group is bonded and an aromatic ring to which the phenolic hydroxy group and/or the alkoxy group derived from a phenolic hydroxy group is bonded is not limited to a noncondensed ring type aromatic ring such as a benzene ring, and may be a condensed ring type aromatic ring such as a naphthalene ring or anthracene.

When a plurality of aromatic rings are present in the molecule of the phenol-based crosslinking agent, the crosslinking-forming group and the phenolic hydroxy group and the alkoxy group derived from a phenolic hydroxy group may be bonded to the same aromatic ring in the molecule or may be bonded to different aromatic rings.

The aromatic ring to which the crosslinking-forming group, the phenolic hydroxy group, and the alkoxy group derived from a phenolic hydroxy group are bonded may be further substituted with an alkyl group such as a methyl group, an ethyl group, or a butyl group, a hydrocarbon group such as an aryl group (for example, a phenyl group), a halogen atom such as a fluorine atom, or the like.

For example, specific examples of the phenol-based crosslinking agent having a crosslinking-forming group include compounds represented by any of Formulas (L1) to (L4) .

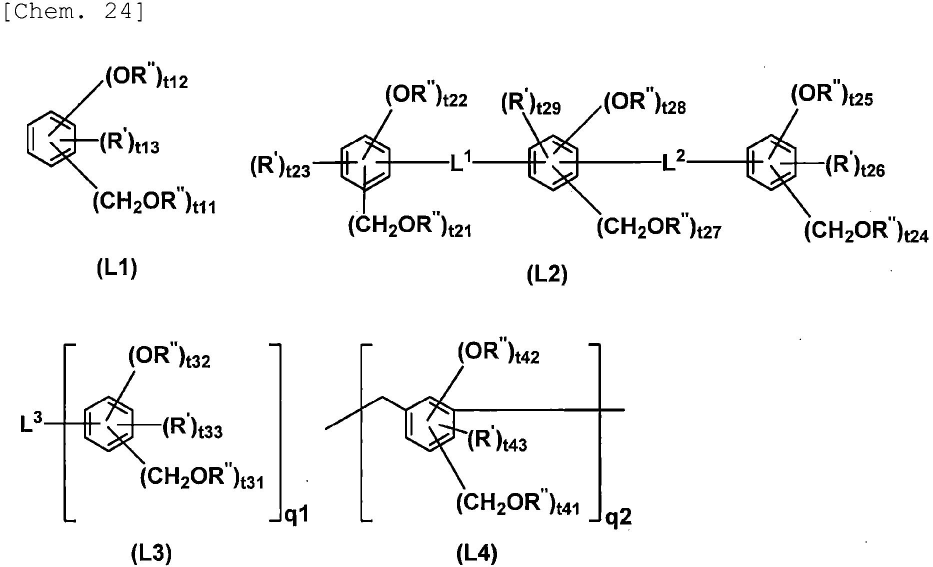

In each formula, each R' independently represents a fluorine atom, an aryl group, or an alkyl group, each R" independently represents a hydrogen atom or an alkyl group, L¹ and L² each independently represent a single bond, a methylene group, or a propane-2,2-diyl group, L³ is determined depending on q1 and represents a single bond, a methylene group, a propane-2,2-diyl group, a methantriyl group, or an ethane-1,1,1-triyl group, t11, t12, and t13 are integers satisfying 2 ≤ t11 ≤ 5, 1 ≤ t12 ≤ 4, 0 ≤ t13 ≤ 3, and t11 + t12 + t13 ≤ 6, t21, t22, and t23 are integers satisfying 2 ≤ t21 ≤ 4, 1 ≤ t22 ≤ 3, 0 ≤ t23 ≤ 2, and t21 + t22 + t23 ≤ 5, t24, t25, and t26 are integers satisfying 2 ≤ t24 ≤ 4, 1 ≤ t25 ≤ 3, 0 ≤ t26 ≤ 2, and t24 + t25 + t26 ≤ 5, t27, t28, and t29 are integers satisfying 0 ≤ t27 ≤ 4, 0 ≤ t28 ≤ 4, 0 ≤ t29 ≤ 4, and t27 + t28 + t29 ≤ 4, t31, t32, and t33 are integers satisfying 2 ≤ t31 ≤ 4, 1 ≤ t32 ≤ 3, 0 ≤ t33 ≤ 2, and t31 + t32 + t33 ≤ 5, t41, t42, and t43 are integers satisfying 2 ≤ t41 ≤ 3, 1 ≤ t42 ≤ 2, 0 ≤ t43 ≤ 1, and t41 + t42 + t43 ≤ 4, q1 is 2 or 3, q2 represents the number of repetitions and is an integer of 0 or more, and specific examples of the aryl group and the alkyl group include those same as the following specific examples, but the aryl group is preferably a phenyl group, and the alkyl group is preferably a methyl group or a t-butyl group.

Hereinafter, specific examples of the compounds represented by the Formulas (L1) to (L4) will be given, but are not limited thereto. Note that these compounds may be synthesized by a known method, and can also be obtained, for example, as a product of Asahi Yukizai Corporation or Honshu Chemical Industry Co., Ltd.

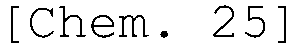

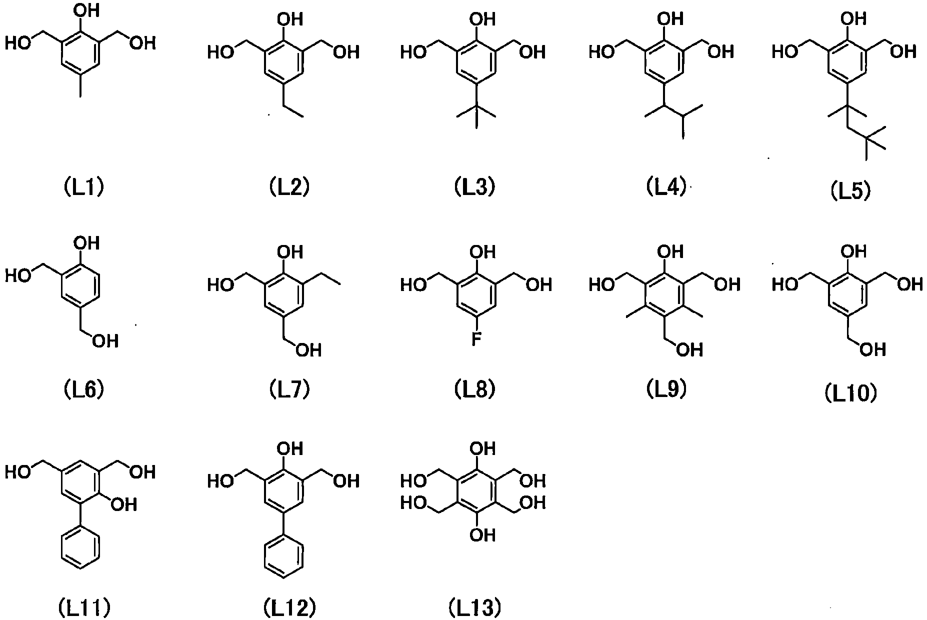

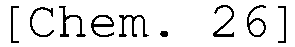

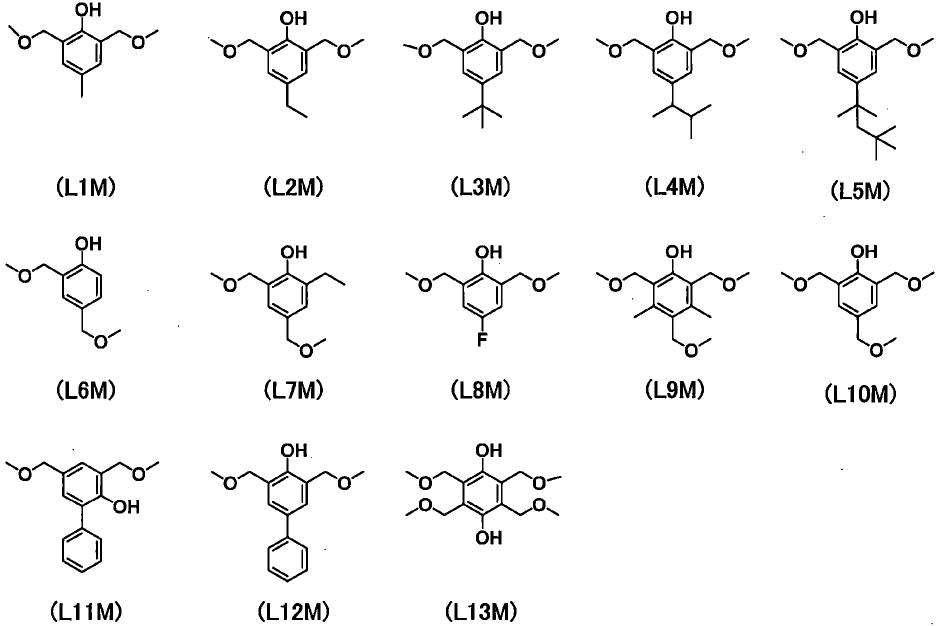

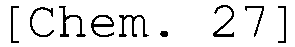

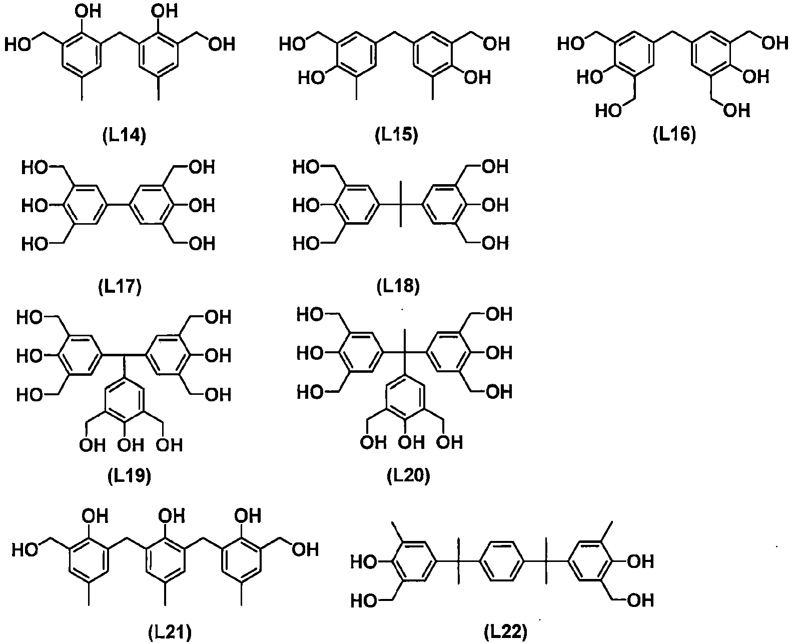

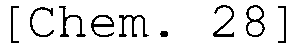

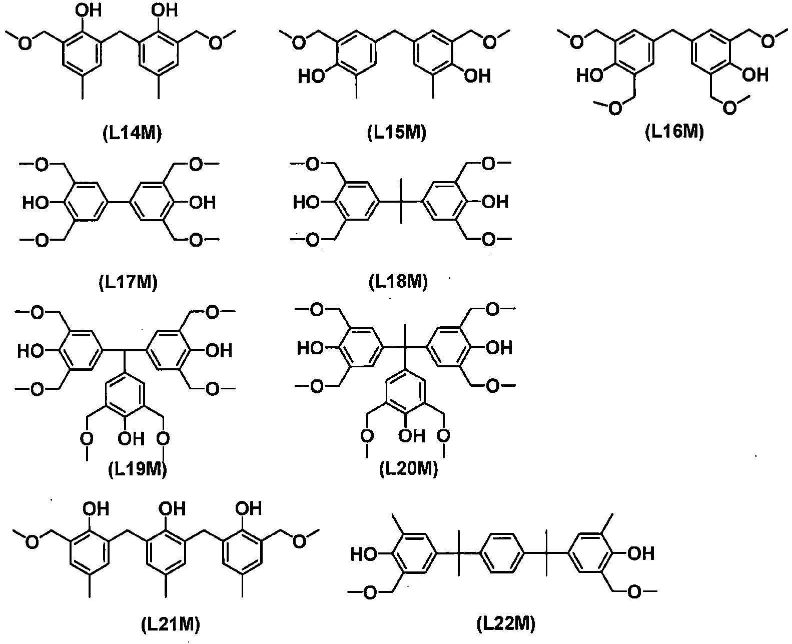

The melamine-based crosslinking agent having a crosslinking-forming group is a melamine derivative, a 2,4-diamino-1,3,5-triazine derivative, or a 2-amino-1,3,5-triazine derivative in which at least one of hydrogen atoms of an amino group bonded to the triazine ring is substituted with a crosslinking-forming group, and the triazine ring may further have a substituent such as an aryl group such as a phenyl group.

Specific examples of the melamine-based crosslinking agent having a crosslinking-forming group include, but are not limited to, mono-, bis-, tris-, tetrakis-, pentakis- or hexakisalkoxymethylmelamines such as N,N,N',N',N",N"-hexakis(methoxymethyl)melamine and N,N,N',N',N",N"-hexakis(butoxymethyl)melamine; and mono-, bis-, tris- or tetrakisalkoxymethylbenzoguanamines such as N,N,N',N'-tetrakis(methoxymethyl)benzoguanamine and N,N,N',N'-tetrakis(butoxymethyl)benzoguanamine.

The urea-based crosslinking agent having a crosslinking-forming group is a derivative of a urea bond-containing compound, and has a structure in which at least one of hydrogen atoms of an NH group constituting a urea bond is substituted with a crosslinking-forming group.

Specific examples of the urea-based crosslinking agent having a crosslinking-forming group include, but are not limited to, mono-, bis-, tris-, or tetrakisalkoxymethylglycolurils such as 1,3,4,6-tetrakis(methoxymethyl)glycoluril and 1,3,4,6-tetrakis(butoxymethyl)glycoluril; and mono-, bis-, tris-, or tetrakisalkoxymethylureas such as 1,3-bis(methoxymethyl)urea and 1,1,3,3-tetrakismethoxymethylurea.

The thiourea-based crosslinking agent having a crosslinking-forming group is a derivative of a thiourea bond-containing compound, and has a structure in which at least one of hydrogen atoms of an NH group constituting a thiourea bond is substituted with a crosslinking-forming group.

Specific examples of the thiourea-based crosslinking agent having a crosslinking-forming group include, but are not limited to, mono-, bis-, tris-, or tetrakisalkoxymethylthioureas such as 1,3-bis(methoxymethyl)thiourea and 1,1,3,3-tetrakismethoxymethylthiourea.

The amount of the crosslinking agent contained in the release agent composition varies depending on the coating method to be employed, the desired film thickness, and the like, and thus cannot be generally determined, but is usually 0.01 to 50 mass% with respect to the organic resin or the polynuclear phenol derivative, and is preferably 0.1 mass% or more, more preferably 1 mass% or more, still more preferably 3 mass% or more, and further preferably 5 mass% or more, and preferably 45 mass% or less, more preferably 40 mass% or less, still more preferably 35 mass% or less, and further preferably 30 mass% or less from the viewpoint of achieving suitable curing and obtaining a laminate in which a semiconductor substrate and a support substrate can be satisfactorily separated from each other with high reproducibility.

### <<<<Acid Generating Agent and Acid>>>>

For the purpose of, for example, promoting the crosslinking reaction, the release agent composition may contain an acid generating agent or an acid.

Examples of the acid generating agent include a thermal acid generating agent and a photoacid generating agent.

The thermal acid generating agent is not particularly limited as long as an acid is generated by heat, and specific examples thereof include, but are not limited to, 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (manufactured by King Industries, Inc.), SI-45, SI-60, SI-80, SI-100, SI-110, and SI-150 (manufactured by Sanshin Chemical Industry Co., Ltd.), and other organic sulfonic acid alkyl esters.

Examples of the photoacid generating agent include onium salt compounds, sulfonimide compounds, and disulfonyldiazomethane compounds.

Specific examples of the onium salt compound include, but are not limited to, iodonium salt compounds such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, and bis(4-tert-butylphenyl)iodonium trifluoromethanesulfonate; and sulfonium salt compounds such as triphenylsulfonium nitrate, triphenylsulfonium hexafluoroantimonate, triphenylsulfonium nonafluoro-normal butanesulfonate, triphenylsulfonium camphorsulfonate, and triphenylsulfonium trifluoromethanesulfonate.

Specific examples of the sulfonimide compound include, but are not limited to, N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Specific examples of the acid include, but are not limited to, arylsulfonic acids and pyridinium salts such as p-toluenesulfonic acid, pyridinium p-toluenesulfonate(pyridinium paratoluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, and 1-naphthalenesulfonic acid, and salts thereof; arylcarboxylic acids such as salicylic acid, benzoic acid, hydroxybenzoic acid, and naphthalenecarboxylic acid, and salts thereof; linear or cyclic alkylsulfonic acids such as trifluoromethanesulfonic acid and camphorsulfonic acid, and salts thereof; and linear or cyclic alkylcarboxylic acids such as citric acid, and salts thereof.

The amounts of the acid generating agent and the acid contained in the release agent composition cannot be generally determined because the amounts vary depending on the type of the crosslinking agent to be used together, the heating temperature at the time of forming the film, and the like, but are usually 0.01 to 5 mass% with respect to the film constituent component.

### <<<<Surfactant>>>>

The release agent composition may contain a surfactant for the purpose of, for example, adjusting the liquid physical properties of the composition itself or the film physical properties of the obtained film, or preparing a highly uniform release agent composition with high reproducibility.

Examples of the surfactant may include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkylaryl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine surfactants such as EFTOP EF301, EF303, and EF352 (manufactured by Tohkemy Corporation, trade name), MEGAFACE F171, F173, R-30, and R-30N (manufactured by DIC Corporation, trade name), FLUORAD FC430 and FC431 (manufactured by Sumitomo 3M Ltd., trade name), ASAHIGUARD AG710, SURFLON S-382, SC101, SC102, SC103, SC104, SC105, and SC106 (manufactured by AGC Inc., trade name); and organosiloxane polymer KP341 (manufactured by Shin-Etsu Chemical Co., Ltd.).

Surfactants can be used alone or in combination of two or more thereof.

The amount of the surfactant is usually 2 mass% or less with respect to the film constituent components of the release agent composition.

### <<<<Solvent>>>>

The release agent composition preferably contains a solvent.

As such a solvent, it is possible to use, for example, a high-polarity solvent capable of satisfactorily dissolving film constituent components such as the organic resin, the polynuclear phenol derivative, the branched polysilane and crosslinking agent, and if necessary, a low-polarity solvent may also be used for purposes such as adjusting viscosity and surface tension. In the present invention, the low-polarity solvent is defined as a solvent having a relative permittivity of less than 7 at a frequency of 100 kHz, and the high-polarity solvent is defined as a solvent having a relative permittivity of 7 or more at a frequency of 100 kHz. The solvents can be used alone or in combination of two or more thereof.

Examples of the high-polarity solvent include amide-based solvents such as N,N-dimethylformamide, N,N-dimethylacetamide, N,N-dimethylisobutyramide, N-methylpyrrolidone, and 1,3-dimethyl-2 imidazolidinone; ketone-based solvent such as ethyl methyl ketone, isophorone, or cyclohexanone; cyano-based solvents such as acetonitrile and 3-methoxypropionitrile; polyhydric alcohol-based solvent such as ethylene glycol, diethylene glycol, triethylene glycol, dipropylene glycol, 1,3-butanediol, or 2,3-butanediol; monohydric alcohol-based solvents other than aliphatic alcohols such as propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol; and sulfoxide-based solvents such as dimethyl sulfoxide.

Examples of the low-polarity solvent include chlorine-based solvents such as chloroform and chlorobenzene; aromatic hydrocarbon-based solvents such as alkylbenzenes (for example, toluene, xylene, tetralin, cyclohexylbenzene, and decylbenzene); aliphatic alcohol-based solvents such as 1-octanol, 1-nonanol, and 1-decanol; ether-based solvent such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, or triethylene glycol butyl methyl ether; and ester-based solvents such as methyl benzoate, ethyl benzoate, butyl benzoate, isoamyl benzoate, bis(2-ethylhexyl)phthalate, dibutyl maleate, dibutyl oxalate, hexyl acetate, propylene glycol monomethyl ether acetate, diethylene glycol monoethyl ether acetate, and diethylene glycol monobutyl ether acetate.

The content of the solvent is appropriately determined in consideration of the viscosity of the desired composition, the coating method to be adopted, the thickness of the film to be prepared, and the like, but is 99 mass% or less of the entire composition, preferably 70 to 99 mass% with respect to the entire composition, that is, the amount of the film constituent component in that case is 1 to 30 mass% with respect to the entire composition.

The viscosity and surface tension of the release agent composition are appropriately adjusted by changing the type of the solvent to be used, the ratio thereof, the concentration of the film constituent component, and the like in consideration of various factors such as the coating method to be used and the desired film thickness.

In an aspect of the present invention, the release agent composition contains a glycol-based solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like. Note that the "glycol-based solvent" as used herein is a generic term for glycols, glycol monoethers, glycol diethers, glycol monoesters, glycol diesters, and glycol ester ethers.

An example of a preferable glycol-based solvent is represented by Formula (G).

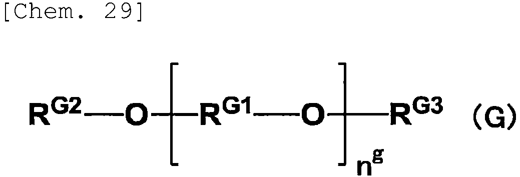

In Formula (G), R^{G1}'s each independently represent a linear or branched alkylene group having 2 to 4 carbon atoms, R^{G2} and R^{G3} each independently represent a hydrogen atom, a linear or branched alkyl group having 1 to 8 carbon atoms, or an alkylacyl group in which the alkyl moiety is a linear or branched alkyl group having 1 to 8 carbon atoms, and n^{g} is an integer of 1 to 6.

Specific examples of the linear or branched alkylene group having 2 to 4 carbon atoms include, but are not limited to, an ethylene group, a trimethylene group, a 1-methylethylene group, a tetramethylene group, a 2-methylpropane-1,3-diyl group, a pentamethylene group, and a hexamethylene group.

Among them, a linear or branched alkylene group having 2 to 3 carbon atoms is preferable, and a linear or branched alkylene group having 3 carbon atoms is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

Among them, a methyl group and an ethyl group are preferable, and a methyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms in the alkylacyl group in which the alkyl moiety is a linear or branched alkyl group having 1 to 8 carbon atoms include the same as the specific examples described above.

Among them, a methylcarbonyl group and an ethylcarbonyl group are preferable, and a methylcarbonyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

n^{g} is preferably 4 or less, more preferably 3 or less, still more preferably 2 or less, and most preferably 1 from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In Formula (G), preferably, at least one of R^{G2} and R^{G3} is a linear or branched alkyl group having 1 to 8 carbon atoms, more preferably, one of R^{G2} and R^{G3} is a linear or branched alkyl group having 1 to 8 carbon atoms, and the other is an alkylacyl group in which a hydrogen atom or an alkyl moiety is a linear or branched alkyl group having 1 to 8 carbon atoms from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The content of the glycol-based solvent is preferably 50 mass% or more, more preferably 70 mass% or more, still more preferably 80 mass% or more, further preferably 90 mass% or more, and even more preferably 95 mass% or more with respect to the solvent contained in the release agent composition from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the release agent composition, the film constituent component is uniformly dispersed or dissolved, preferably dissolved in the solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The release agent composition can be produced by, for example, mixing the organic resin or the polynuclear phenol derivative, the solvent, and the crosslinking agent as necessary.

The mixing order is not particularly limited, and examples of a method capable of easily producing the release agent composition with good reproducibility include, but are not limited to, a method in which the organic resin or the polynuclear phenol derivative and the crosslinking agent are dissolved in the solvent at once and a method in which the organic resin or the polynuclear phenol derivative and a part of the crosslinking agent are dissolved in the solvent, the residue is separately dissolved in the solvent, and each of the obtained solutions is mixed together. Note that when the release agent composition is prepared, the components may be heated, if appropriate, as long as the components are not decomposed or altered.

In the present invention, for the purpose of removing foreign matter, a solvent, a solution, or the like to be used may be filtered using a filter or the like during the production of the release agent composition or after mixing all the components.

The thickness of the release agent layer is not particularly limited and is usually 5 nm to 100 µm, 10 nm to 10 µm in an aspect, 50 nm to 1 µm in another aspect, and 100 nm to 700 nm in still another aspect.

A method for forming the release agent layer from the release agent composition is not particularly limited, and examples thereof include a method in which the release agent layer is formed by applying the release agent composition.

The coating method for the release agent composition is not particularly limited, but is usually a spin coating method.

The heating temperature of the applied release agent composition varies depending on the type and amount of the release agent component contained in the release agent composition, the desired thickness of the release agent layer, and the like, and thus cannot be generally determined, but from the viewpoint of achieving a suitable release agent layer with good reproducibility, the heating temperature is 80°C or more and 300°C or less, and the heating time is appropriately determined usually in the range of 10 seconds to 10 minutes depending on the heating temperature. The heating temperature is preferably 100°C or higher and 280°C or lower, and more preferably 150°C or higher and 250°C or lower. The heating time is preferably 30 seconds or more and 8 minutes or less, and more preferably 1 minute or more and 5 minutes or less.

The heating can be performed using a hot plate, an oven, or the like.

Hereinafter, an example of the configuration of the laminate of the first embodiment will be described with reference to the drawings.

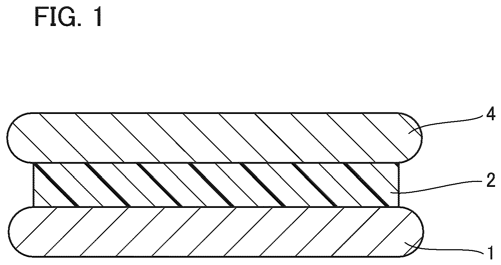

Fig. 1 shows a schematic cross-sectional view of an example of a laminate of the first embodiment.

The laminate of Fig. 1 includes the semiconductor substrate 1, the adhesive layer 2, and the support substrate 4 in this order. The adhesive layer 2 is provided between the semiconductor substrate 1 and the support substrate 4. The adhesive layer 2 is in contact with the semiconductor substrate 1 and the support substrate 4.

Hereinafter, another example of the configuration of the laminate of the first embodiment will be described with reference to the drawings.

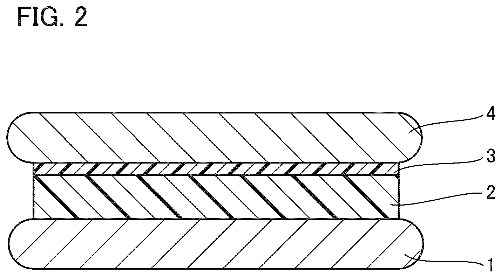

Fig. 2 shows a schematic cross-sectional view of another example of the laminate of the first embodiment.

The laminate of Fig. 2 includes the semiconductor substrate 1, the adhesive layer 2, a release agent layer 3, and the support substrate 4 in this order.

The adhesive layer 2 and the release agent layer 3 are provided between the semiconductor substrate 1 and the support substrate 4. The adhesive layer 2 is in contact with the semiconductor substrate 1. The release agent layer 3 is in contact with the adhesive layer 2 and the support substrate 4.

### <<Method for Producing One Example of Laminate in First Embodiment>>

A method for producing a laminate will be described below with the laminate shown in Fig. 1 as an example of the laminate in the first embodiment.

An example of the laminate of the present invention can be produced, for example, by a method including the following Steps 1 and 2.
Step 1: a step of applying an adhesive composition onto a semiconductor substrate to form an adhesive coating layer
Step 2: a step of heating the adhesive coating layer to form an adhesive layer

The coating method for the adhesive composition is not particularly limited, but is usually a spin coating method. Note that a method for separately forming a coating film by a spin coating method or the like, forming a sheet-like coating film, and sticking the sheet-like coating film as an adhesive coating layer can be adopted.

The heating temperature of the applied adhesive composition varies depending on the type and amount of the adhesive component contained in the adhesive composition, whether or not a solvent is contained, the boiling point of the solvent to be used, the desired thickness of the adhesive layer, and the like, and thus cannot be generally determined, but the heating temperature is usually 80 to 150°C, and the heating time is usually 30 seconds to 5 minutes.

When the adhesive composition contains a solvent, the applied adhesive composition is usually heated.

The film thickness of an adhesive coating layer obtained by applying an adhesive composition and heating the adhesive composition, if necessary, is usually about 5 to 500 µm, and finally, is appropriately determined to fall within the above-described range of the thickness of the adhesive layer.

In the present invention, the laminate of the present invention can be obtained by applying a load in the thickness direction of the semiconductor substrate and the support substrate while performing heat treatment or decompression treatment or both thereof, and then performing post-heat treatment. Note that the treatment conditions to be adopted, whether heat treatment, decompression treatment, or a combination of both, are appropriately determined taking into consideration various factors such as the type of adhesive composition, the film thickness, and the desired adhesive strength.

The heat treatment is appropriately determined from the range of usually 20 to 160°C from the viewpoint of removing the solvent from the composition. In particular, from the viewpoint of suppressing or avoiding excessive curing and unnecessary alteration of the adhesive component (A), the heating temperature is preferably 150°C or lower, and more preferably 130°C or lower, and the heating time is appropriately determined depending on the heating temperature and the type of the adhesive. However, from the viewpoint of reliably exhibiting suitable adhesion, the heating time is usually 30 seconds or longer, and preferably 1 minute or longer. From the viewpoint of suppressing alteration of the adhesive layer and other members, the heating time is usually 10 minutes or shorter, preferably 5 minutes or shorter.

In the decompression treatment, the adhesive coating layer and the release agent layer in contact with each other may be exposed to an atmospheric pressure of 10 to 10,000 Pa. The time for the decompression treatment is usually 1 to 30 minutes.

The load in the thickness direction of the semiconductor substrate and the support substrate is not particularly limited as long as the load does not adversely affect the semiconductor substrate, the support substrate, and those layers therebetween, and can bring them into close contact with each other, but is usually within the range of 10 to 50,000 N.

The temperature of the post-heating is preferably 120°C or higher from the viewpoint of achieving a sufficient curing rate and the like, and is preferably 260°C or lower from the viewpoint of preventing alteration of the substrate and each layer, and the like.

The post-heating time is usually 1 minute or more, and preferably 5 minutes or more from the viewpoint of achieving suitable bonding of the substrate and the layer constituting the laminate, and is usually 180 minutes or less, and preferably 120 minutes or less from the viewpoint of suppressing or avoiding an adverse effect on each layer due to excessive heating, and the like.

The heating can be performed using a hot plate, an oven, or the like. When post-heating is performed using a hot plate, heating may be performed with either the semiconductor substrate or the support substrate of the laminate facing downward. Preferably, post-heating is performed with the semiconductor substrate facing downward from the viewpoint of achieving suitable release with excellent reproducibility.

Note that one object of the post-heat treatment is to achieve an adhesive layer as a more preferable self-standing film, and to suitably achieve, particularly, curing by a hydrosilylation reaction.

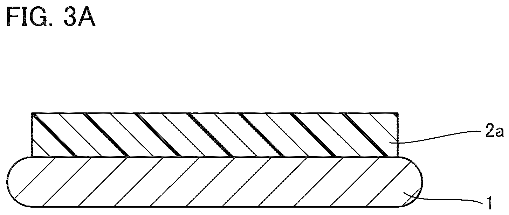

Figs. 3A to 3C are views for describing one aspect of production of the laminate.

First, a laminate in which an adhesive coating layer 2a is formed on the semiconductor substrate 1 is prepared (Fig. 3A). This laminate can be obtained, for example, by applying the adhesive composition onto the semiconductor substrate 1, followed by heating.

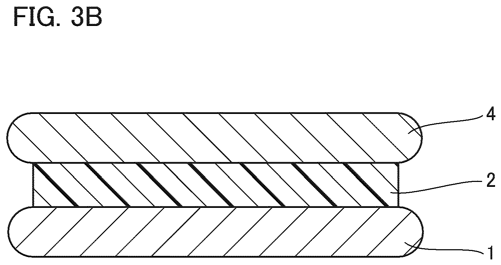

Next, the laminate shown in Fig. 3A and the support substrate 4 are bonded to each other such that the adhesive coating layer 2a and the support substrate 4 are in contact with each other. Then, after a load is applied in the thickness direction between the semiconductor substrate 1 and the support substrate 4 under reduced pressure, a heating device (not shown; a hot plate) is disposed on the surface opposite to a surface of the semiconductor substrate 1 with which the adhesive coating layer 2a is in contact, and the adhesive coating layer 2a is heated and cured by the heating device to be converted into the adhesive layer 2 (Fig. 3B).

The laminate shown in Fig. 1 is obtained by the steps shown in Figs. 3A and 3B.

### <Second Embodiment>

The laminate having an electronic device layer is used for processing of the electronic device layer. While the electronic device layer is being processed, the electronic device layer is adhered to the support substrate. After the electronic device layer is processed, the electronic device layer is separated from the support substrate.

### <<Electronic Device Layer>>

The electronic device layer refers to a layer having an electronic device, and in the present invention, refers to a layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member constituting at least a part of an electronic component. The electronic device is not particularly limited, and can be one in which various mechanical structures and circuits are formed on the surface of a semiconductor substrate. The electronic device is preferably a composite of a member made of metal or a semiconductor and a resin that seals or insulates the member. The electronic device may be one in which a rewiring layer, which will be described later, and/or a semiconductor element or other elements are sealed or insulated with a sealing material or an insulating material, and has a single-layer or multi-layer structure.

### <<Support Substrate>>

As the support substrate, those similar to those described in the section of <<Support substrate>> above of <First embodiment> above are exemplified.

### <<Release Agent Layer>>

The release agent layer is formed using the release agent composition for release by irradiation with light of the present invention described above.

The detailed description of the release agent layer is as described in the section of <<Release Agent Layer>> above of <First embodiment> above.

### <<Adhesive Layer>>

The adhesive layer is formed using the adhesive composition described above.

The detailed description of the adhesive layer is as described in the section of <<Adhesive Layer>> above of <First Embodiment> above.

Hereinafter, an example of the configuration of the laminate of the second embodiment will be described with reference to the drawings.

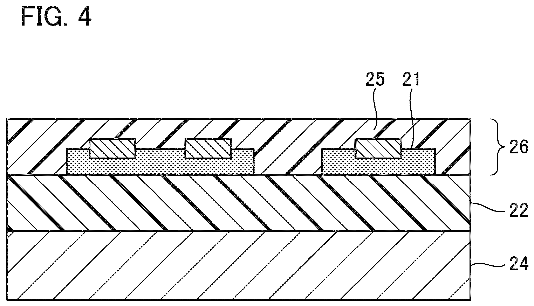

The laminate in Fig. 4 includes a support substrate 24, an adhesive layer 22, and an electronic device layer 26 in this order.

The electronic device layer 26 includes a plurality of semiconductor chip substrates 21 and a sealing resin 25 which is a sealing material disposed between the semiconductor chip substrates 21.

The adhesive layer 22 is provided between the electronic device layer 26 and the support substrate 24. The adhesive layer 22 is in contact with the electronic device layer 26 and the support substrate 24.

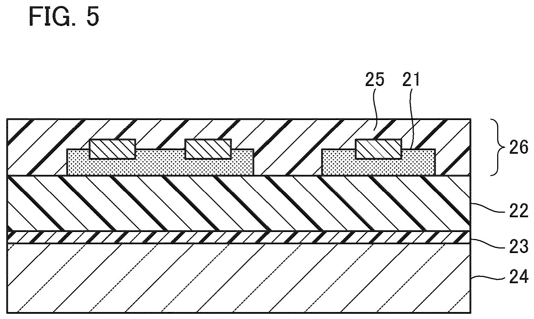

Fig. 5 shows a schematic cross-sectional view of another example of the laminate of the second embodiment.

The laminate of Fig. 5 includes the support substrate 24, a release agent layer 23, the adhesive layer 22, and the electronic device layer 26 in this order.

The electronic device layer 26 includes a plurality of semiconductor chip substrates 21 and a sealing resin 25 which is a sealing material disposed between the semiconductor chip substrates 21.

The adhesive layer 22 and the release agent layer 23 are provided between the electronic device layer 26 and the support substrate 24. The adhesive layer 22 is in contact with the electronic device layer 26. The release agent layer 23 is in contact with the adhesive layer 22 and the support substrate 24.

### <<Method for Producing One Example of Laminate in Second Embodiment>>

A method for producing a laminate will be described below with the laminate shown in Fig. 4 as an example of the laminate in the second embodiment.

The laminate of the present invention can be produced, for example, by a method including the following Steps 1 to 4.
Step 1: a step of coating a surface of the support substrate with the adhesive composition to form an adhesive coating layer (if necessary, further heating is performed to form an adhesive layer)
Step 2: a step of placing a semiconductor chip substrate on the adhesive coating layer or the adhesive layer, and bonding the semiconductor chip substrate to the adhesive coating layer or the adhesive layer while performing at least one of heat treatment and decompression treatment
Step 3: a step of curing the adhesive coating layer by post-heat treatment to form an adhesive layer
Step 4: a step of sealing the semiconductor chip substrate fixed onto the adhesive layer using a sealing resin

To describe the second step in more detail, for example, there is the following step (i) of the embodiment.
(i) The semiconductor chip substrate is placed on the adhesive coating layer or the adhesive layer, and while at least one of the heat treatment and the decompression treatment is performed, a load is applied in the thickness direction of the semiconductor chip substrate and the support substrate to bring the semiconductor chip substrate and the support substrate into close contact with each other, and the semiconductor chip substrate is bonded to the adhesive coating layer or the adhesive layer.

Furthermore, Step 3 may be performed after the semiconductor chip substrate in Step 2 is bonded to the adhesive coating layer, or may be performed in combination with Step 2. For example, by placing the semiconductor chip substrate on the adhesive coating layer and heating and curing the adhesive coating layer while applying a load in the thickness direction of the semiconductor chip substrate and the support substrate, adhesion between the semiconductor chip substrate and the adhesive coating layer and curing from the adhesive coating layer to the adhesive layer may be performed together, and the adhesive layer and the semiconductor chip substrate may be bonded to each other.

In addition, Step 3 may be performed before Step 2, the semiconductor chip substrate may be placed on the adhesive layer while applying a load in the thickness direction of the semiconductor chip substrate and the support substrate, the adhesive layer and the semiconductor chip substrate may be bonded to each other.

The coating method, the heating temperature of the applied adhesive composition, the heating means and the like are as described in <<Method for Producing One Example of Laminate in First Embodiment>> above of <First Embodiment> above.

Hereinafter, the procedure of the method for producing a laminate of the second embodiment will be described in more detail with reference to the drawings. In this production method, the laminate shown in Fig. 4 is produced.

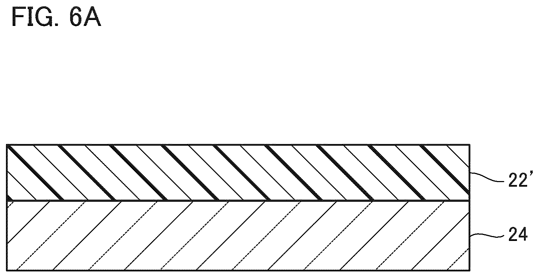

As shown in Fig. 6A, an adhesive coating layer 22' made of the adhesive composition is formed on the support substrate 24. At that time, the adhesive coating layer 22' may be heated to form an adhesive layer 22.

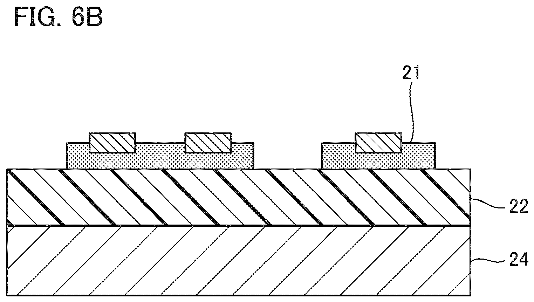

Next, as shown in Fig. 6B, the semiconductor chip substrate 21 is placed on the adhesive layer 22 or the adhesive coating layer 22', and while at least one of the heat treatment and the decompression treatment is performed, a load is applied in the thickness direction of the semiconductor chip substrate 21 and the support substrate 24 to bring the semiconductor chip substrate 21 and the support substrate 24 into close contact with each other, and the semiconductor chip substrate 21 is bonded to the adhesive layer 22 or the adhesive coating layer 22'. When the semiconductor chip substrate 21 is bonded to the adhesive coating layer 22', the adhesive coating layer 22' is cured by post-heat treatment to form the adhesive layer 22, and the semiconductor chip substrate 21 is fixed to the adhesive layer 22.

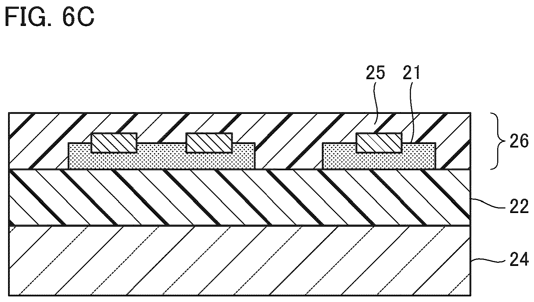

Next, as shown in Fig. 6C, the semiconductor chip substrate 21 fixed onto the adhesive layer 22 is sealed using the sealing resin 25. In Fig. 6C, the plurality of semiconductor chip substrates 21 temporarily adhered onto the support substrate 24 via the adhesive layer 22 is sealed with the sealing resin 25. The electronic device layer 26, which includes the semiconductor chip substrate 21 and the sealing resin 25 between the semiconductor chip substrates 21, is formed on the adhesive layer 22, and in this manner, the electronic device layer 26 is a base material layer in which a plurality of semiconductor chip substrates are embedded in the sealing resin.

### <<<Sealing Step>>>

The semiconductor chip substrate 21 is sealed using a sealing material.

As the sealing material for sealing the semiconductor chip substrate 21, a member capable of insulating or sealing a member made of metal or a semiconductor is used.

In the present invention, for example, a resin composition (sealing resin) is used as the sealing material. The type of the sealing resin is not particularly limited as long as the sealing resin can seal and/or insulate metal or a semiconductor, but for example, an epoxy-based resin or a silicone-based resin is preferably used.

The sealing material may contain, in addition to the resin component, other components such as a filler. Examples of the filler include spherical silica particles.

In the sealing step, for example, the sealing resin heated to 130 to 170°C is supplied onto the adhesive layer 22 to cover the semiconductor chip substrate 21 while maintaining a high viscosity state, and is compression-molded to form a layer including the sealing resin 25 on the adhesive layer 22. At this time, the temperature condition is, for example, 130 to 170°C. In addition, the pressure applied to the semiconductor chip substrate 21 is, for example, 50 to 500 N/cm².

### (Method for Producing Processed Semiconductor Substrate or Electronic Device Layer)

When the laminate according to the present invention is used, a method for producing a processed semiconductor substrate or a method for producing a processed electronic device layer can be provided.

In the "method for producing a processed semiconductor substrate", the laminate described in the section of <First embodiment> above of the (Laminate) above is used. In addition, in the "method for producing a processed electronic device layer", the laminate described in the section of <Second Embodiment> above of the (Laminate) above is used.

The "method for producing a processed semiconductor substrate" will be described in <Third Embodiment> below, and the "method for producing a processed electronic device layer" will be described in <Fourth Embodiment> below.

### <Third Embodiment>

The method for producing a processed semiconductor substrate of the present invention includes the following Step 5A and the following Step 6A. The method for producing the processed electronic device layer may further include the following Step 7A.

Here, Step 5A is a step of processing the semiconductor substrate in the laminate described in the section of <First Embodiment> above.

In addition, Step 6A is a step of separating the semiconductor substrate processed in Step 5A and the support substrate from each other.

In addition, Step 7A is a step of cleaning the processed semiconductor substrate after Step 6A.

The processing performed on the semiconductor substrate in Step 5A is, for example, processing on the side opposite to the circuit surface of the wafer, and includes thinning of the wafer by polishing the back surface of the wafer. Thereafter, for example, a through-silicon via (TSV) or the like is formed, and then the thinned wafer is released from the support substrate to form a laminate of wafers which are three-dimensionally mounted. In addition, for example, before and after that, a wafer back surface electrode and the like are also formed. Heat of approximately 250 to 350°C is applied to thinning of a wafer and a TSV process in a state of being adhered to the support substrate. The laminate of the present invention ordinarily includes the adhesive layer to provide heat resistance to the load.

Note that the processing is not limited to the above-described processing, and includes, for example, implementation of a process of mounting a semiconductor component in a case where the semiconductor component is temporarily adhered to the support substrate in order to support a base material for mounting the semiconductor component.

A method for separating (releasing) the semiconductor substrate and the support substrate in Step 6A is not particularly limited.

Examples thereof include a method in which the semiconductor substrate and the support substrate are mechanically released with equipment having a sharp part (so-called a die bonder). Specifically, for example, the sharp part is inserted between the semiconductor substrate and the support substrate, and the semiconductor substrate and the support substrate are then separated from each other.

In addition, when the laminate includes the release agent layer, the method for separating (releasing) the semiconductor substrate and the support substrate in Step 6A may be releasing or the like in which the release agent layer is irradiated with light, and the semiconductor substrate and the support substrate are then torn off.

By irradiating the release agent layer with light from the support substrate side, the release agent layer is altered (for example, the release agent layer is separated or decomposed) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other by a slight external force such as pulling up of the support substrate as long as the release agent layer as a whole has sufficiently improved releasing ability. The ratio and positional relationship between the region irradiated with light and the region not irradiated with light vary depending on the type and specific composition of the adhesive to be used, the thickness of the adhesive layer, the thickness of the adhesive layer, the thickness of the release agent layer, the intensity of light to be emitted, and the like, but those skilled in the art can appropriately set conditions without requiring an excessive test. For such circumstances, according to the method for producing a processed semiconductor substrate of the present invention, for example, in a case where the support substrate of the laminate to be used is light-transmissive, it is possible to shorten the irradiation time with light when release is performed by irradiation with light from the support substrate side, and as a result, not only improvement in throughput can be expected, but also physical stress and the like required for release can be avoided, and the semiconductor substrate and the support substrate can be easily and efficiently separated from each other only by irradiation with light.

The light irradiation amount for release is usually 50 to 3,000 mJ/cm². The irradiation time is appropriately determined depending on the wavelength and the light irradiation amount.

The wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The light irradiation amount required for release is a light irradiation amount that can cause suitable alteration, for example, decomposition of the specific compound and polymer.

The light used for release may be laser light or non-laser light emitted from a light source such as an ultraviolet lamp.

The substrate can be cleaned by spraying a cleaning agent composition onto the surface of at least one of the separated semiconductor substrate and the support substrate, or immersing the separated semiconductor substrate or the support substrate in a cleaning agent composition.

In addition, the surface of the processed semiconductor substrate or the like may be cleaned using a removal tape or the like.

As an example of cleaning the substrate, Step 7A of cleaning the processed semiconductor substrate may be performed after Step 6A.

Examples of the cleaning agent composition to be used for cleaning include the following.

The cleaning agent composition usually contains a solvent.

Examples of the solvent include lactones, ketones, polyhydric alcohols, compounds having an ester bond, derivatives of polyhydric alcohols, cyclic ethers, esters, and aromatic organic solvents.

Examples of the lactones include γ-butyrolactone.

Examples of the ketones include acetone, methyl ethyl ketone, cyclohexanone, methyl-n-pentyl ketone, methyl isopentyl ketone, and 2-heptanone.

Examples of the polyhydric alcohols include ethylene glycol, diethylene glycol, propylene glycol, and dipropylene glycol.

Examples of the compound having an ester bond include ethylene glycol monoacetate, diethylene glycol monoacetate, propylene glycol monoacetate, and dipropylene glycol monoacetate.

Examples of the derivatives of polyhydric alcohol include monoalkyl ethers such as monomethyl ether, monoethyl ether, monopropyl ether, and monobutyl ether of the polyhydric alcohols or the compounds having an ester bond, or compounds having an ether bond such as monophenyl ether. Among them, propylene glycol monomethyl ether acetate (PGMEA) and propylene glycol monomethyl ether (PGME) are preferable.

Examples of the cyclic ethers include dioxane.

Examples of the esters include methyl lactate, ethyl lactate (EL), methyl acetate, ethyl acetate, butyl acetate, methyl pyruvate, ethyl pyruvate, methyl methoxypropionate, and ethyl ethoxypropionate.

Examples of the aromatic organic solvents include anisole, ethyl benzyl ether, cresyl methyl ether, diphenyl ether, dibenzyl ether, phenetol, butyl phenyl ether, ethylbenzene, diethylbenzene, pentylbenzene, isopropylbenzene, toluene, xylene, cymene, and mesitylene.

These can be used alone or in combination of two or more thereof.

Among them, propylene glycol monomethyl ether acetate (PGMEA), propylene glycol monomethyl ether (PGME), cyclohexanone, and ethyl lactate (EL) are preferable.

In addition, a mixed solvent obtained by mixing PGMEA and a polar solvent is also preferable. The blending ratio (mass ratio) may be appropriately determined in consideration of compatibility between PGMEA and the polar solvent or the like, and is preferably in the range of 1:9 to 9:1, and more preferably 2:8 to 8:2.

For example, when EL is blended as the polar solvent, the mass ratio of PGMEA:EL is preferably 1:9 to 9:1, and more preferably 2:8 to 8:2. In addition, when PGME is blended as the polar solvent, the mass ratio of PGMEA:PGME is preferably 1: 9 to 9:1, more preferably 2:8 to 8:2, and still more preferably 3:7 to 7:3. In addition, when PGME and cyclohexanone are blended as the polar solvent, the mass ratio of PGMEA: (PGME + cyclohexanone) is preferably 1:9 to 9:1, more preferably 2:8 to 8:2, still more preferably 3:7 to 7:3.

The cleaning agent composition may contain or may not contain a salt, but it is preferable that the cleaning agent composition does not contain a salt from the viewpoint of enhancing versatility in processing a semiconductor substrate using a laminate, and suppressing cost.

An example of the case where the cleaning agent composition contains a salt includes a cleaning agent composition containing a quaternary ammonium salt and a solvent.

The quaternary ammonium salt is composed of a quaternary ammonium cation and an anion, and is not particularly limited as long as the quaternary ammonium salt is used for this type of application.

Such quaternary ammonium cations typically include tetra (hydrocarbon) ammonium cations. On the other hand, examples of an anion paired therewith include, but are not limited to, a hydroxide ion (OH⁻); a halogen ion such as a fluorine ion (F⁻), a chlorine ion (Cl⁻), a bromine ion (Br⁻), and an iodine ion (I⁻); a tetrafluoroborate ion (BF₄⁻); or a hexafluorophosphate ion (PF₆⁻).

The quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferable aspect, the fluorine-containing quaternary ammonium salt is tetra(hydrocarbon)ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferable aspect, the tetra (hydrocarbon) ammonium fluoride contains tetraalkylammonium fluoride.

Specific examples of tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferable.

As the quaternary ammonium salt such as tetra(hydrocarbon)ammonium fluoride, a hydrate may be used. In addition, the quaternary ammonium salts such as tetra(hydrocarbon)ammonium fluoride may be used alone or in combination of two or more thereof.

The amount of the quaternary ammonium salt is not particularly limited as long as the quaternary ammonium salt dissolves in the solvent contained in the cleaning agent composition, but is usually 0.1 to 30 mass% with respect to the cleaning agent composition.

When the cleaning agent composition contains a salt, the solvent to be used in combination is not particularly limited as long as the solvent is used for this type of application and dissolves a salt such as a quaternary ammonium salt, but from the viewpoint of obtaining a cleaning agent composition having excellent cleanability with good reproducibility, the viewpoint of obtaining a cleaning agent composition having excellent uniformity by dissolving a salt such as a quaternary ammonium salt well, and the like, the cleaning agent composition preferably contains one or more amide-based solvents.

Suitable examples of the amide-based solvents include an acid amide derivative represented by Formula (Z).

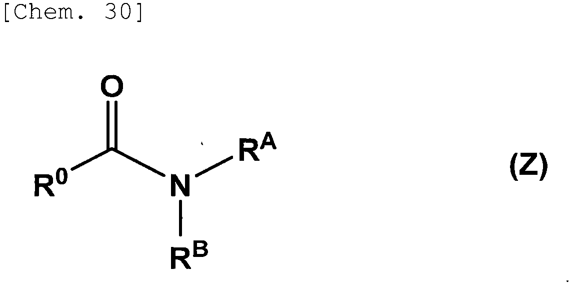

In the formula, R⁰ represents an ethyl group, a propyl group or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, R^{A} and R^{B} are preferably a methyl group or an ethyl group, more preferably a methyl group or an ethyl group, and still more preferably a methyl group.

Examples of the acid amide derivative represented by Formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, or N-ethyl-N-methylisobutyramide. Among them, N,N-dimethylpropionamide and N,N-dimethylisobutyramide are particularly preferable, and N,N-dimethylpropionamide is more preferable.

The acid amide derivative represented by Formula (Z) may be synthesized by a substitution reaction between a corresponding carboxylic acid ester and an amine, or a commercially available product may be used.

Another example of the preferable amide-based solvents includes a lactam compound represented by Formula (Y).

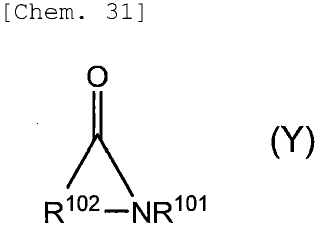

In Formula (Y), R¹⁰¹ represents a hydrogen atom or an alkyl group having 1 to 6 carbon atoms, and R¹⁰² represents an alkylene group having 1 to 6 carbon atoms. Specific examples of the alkyl group having 1 to 6 carbon atoms include a methyl group, an ethyl group, an n-propyl group, and an n-butyl group, and specific examples of the alkylene group having 1 to 6 carbon atoms include, but are not limited to, a methylene group, an ethylene group, a trimethylene group, a tetramethylene group, a pentamethylene group, and a hexamethylene group.

Specific examples of the lactam compound represented by Formula (Y) may include an α-lactam compound, a β-lactam compound, a γ-lactam compound, and a δ-lactam compound, and these compounds can be used alone or in combination of two or more thereof.

In a preferable aspect, the lactam compound represented by Formula (Y) contains 1-alkyl-2 pyrrolidone (N-alkyl-γ-butyrolactam), in a more preferable aspect, N-methylpyrrolidone (NMP) or N-ethylpyrrolidone (NEP), and in a still more preferable aspect, N-methylpyrrolidone (NMP).

Note that the cleaning agent composition used in the present invention may contain water as the solvent, but usually, only an organic solvent is intended to be used as the solvent, for example, from the viewpoint of avoiding corrosion of the substrate and the like. Note that in this case, it is not denied that hydrated water of the salt or trace amounts of water contained in the organic solvent is contained in the cleaning agent composition. The water content of the cleaning agent composition used in the present invention is usually 5 mass% or less.

The constituent elements and method elements related to the above-described steps of the method for producing a processed semiconductor substrate of the present invention may be variously changed without departing from the gist of the present invention.

The method for producing a processed semiconductor substrate of the present invention may include steps other than the above-described steps.

In the releasing method of the present invention, when the semiconductor substrate or the support substrate of the laminate of the present invention is light-transmissive, the semiconductor substrate and the support substrate of the laminate are separated from each other by irradiating the release agent layer with light from the semiconductor substrate side or the support substrate side.

In an example of the laminate of the present invention, since the semiconductor substrate and the support substrate are temporarily adhered to each other by the adhesive layer and the release agent layer to be suitably releasable, for example, when the support substrate is light-transmissive, the semiconductor substrate and the support substrate can be easily separated from each other by irradiating the release agent layer with light from the support substrate side of the laminate. Usually, release is performed after the semiconductor substrate of the laminate is processed.

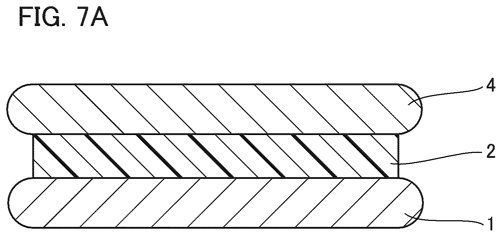

An example of the third embodiment will be described with reference to Figs. 7A to 7D. This example is an example of production of a thinned semiconductor substrate.

First, a laminate is prepared (Fig. 7A). This laminate is the same laminate as the laminate shown in Figs. 1 and 3B.

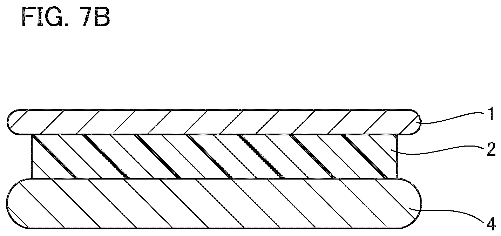

Next, the surface of the semiconductor substrate 1 opposite to a surface in contact with the adhesive layer 2 is polished using a polishing apparatus (not shown) to thin the semiconductor substrate 1 (Fig. 7B). Note that a through electrode may be formed on the thinned semiconductor substrate 1.

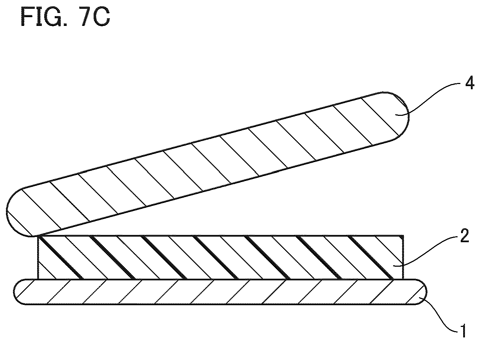

Next, the thinned semiconductor substrate 1 and the support substrate 4 are separated from each other using a releasing apparatus (not shown) (Fig. 7C).

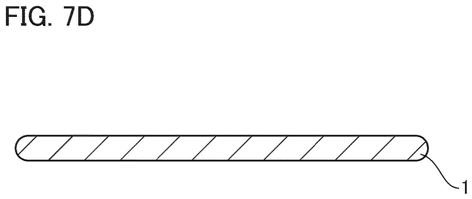

Then, the thinned semiconductor substrate 1 is obtained (Fig. 7D).

Here, the residue of the adhesive layer 2 may remain on the thinned semiconductor substrate 1. Accordingly, it is preferable to clean the thinned semiconductor substrate 1 using the cleaning agent composition to remove the residue of the adhesive layer 2 from the semiconductor substrate 1.

### <Fourth Embodiment>

The method for producing a processed electronic device layer of the present invention includes the following Step 5B and the following Step 6B. The method for producing a processed electronic device layer may further include the following Step 7B.

Here, Step 5B is a step of processing the electronic device layer in the laminate described in the section of <Second Embodiment> above.

In addition, Step 6B is a step of separating the electronic device layer processed in Step 5B from the support substrate.

In addition, Step 7B is a step of cleaning the processed electronic device layer after Step 6B.

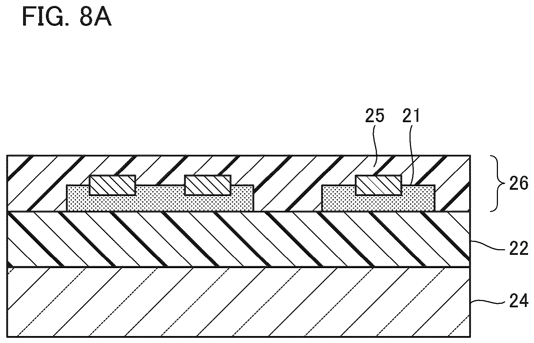

Hereinafter, a specific example of the fourth embodiment will be described with reference to Figs. 8A to 8F.

Examples of the processing performed on the electronic device layer in Step 5B include a grinding step and a wiring layer forming step.

### <<Grinding Step>>

The grinding step is a step of grinding the resin part of the layer of the sealing resin 25 in the electronic device layer 26 such that a part of the semiconductor chip substrate 21 is exposed.

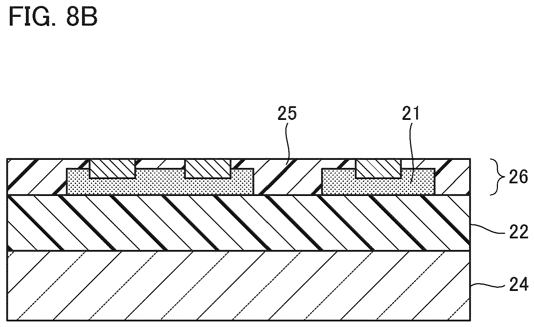

For example, as shown in Fig. 8B, the sealing resin part is ground by grinding the layer of the sealing resin 25 of the laminate shown in Fig. 8A until the layer has a thickness substantially equal to that of the semiconductor chip substrate 21. Note that the laminate shown in Fig. 8A is the same laminate as the laminate shown in Fig. 4 and Fig. 6C.

### <<Wiring Layer Forming Step>>

The wiring layer forming step is a step of forming a wiring layer on the exposed semiconductor chip substrate 21 after the grinding step.

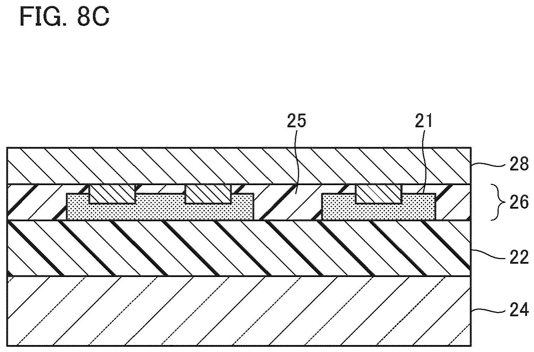

In Fig. 8C, a wiring layer 28 is formed on the electronic device layer 26 including a layer of the semiconductor chip substrate 21 and the sealing resin 25.

The wiring layer 28 is also called a redistribution layer (RDL), is a thin-film wiring body constituting wiring connected to a substrate, and may have a single-layer or multi-layer structure. The wiring layer may be, but is not limited to, one in which wiring is formed of a conductor (for example, metals such as aluminum, copper, titanium, nickel, gold, and silver, and alloys such as a silver-tin alloy) between dielectrics (for example, photosensitive resin such as silicon oxide (SiOₓ) and photosensitive epoxy).

Examples of the method for forming the wiring layer 28 include the following methods.

First, a dielectric layer of silicon oxide (SiOₓ), a photosensitive resin, or the like is formed on the layer of the sealing resin 25. The dielectric layer made of silicon oxide can be formed by, for example, a sputtering method, a vacuum vapor deposition method, or the like. The dielectric layer made of a photosensitive resin can be formed by coating the layer of the sealing resin 25 with a photosensitive resin by a method such as spin coating, dipping, roller blade, spray coating, or slit coating.

Subsequently, wiring is formed on the dielectric layer with a conductor such as metal. As a method for forming the wiring, for example, known semiconductor process techniques such as lithography processing such as photolithography (registry lithography) or etching processing can be used. Examples of such lithography processing include lithography processing using a positive resist material and lithography processing using a negative resist material.

In the method for producing a laminate according to a fourth embodiment, a bump can be further formed or an element can be mounted on the wiring layer 28. The element can be mounted on the wiring layer 28 using, for example, a chip mounter or the like.

The laminate according to the fourth embodiment may be a laminate prepared in a process based on a fan-out type technology in which a terminal provided on a semiconductor chip substrate is mounted on a wiring layer extending outside a chip area.

In Step 6B, examples of the method for separating (releasing) the electronic device layer and the support substrate include, but are not limited to, a method for mechanical releasing with equipment having a sharp portion, a method for releasing by pulling apart between the support and the electronic device layer, and the like.

When the laminate includes the release agent layer, the release agent layer is altered (for example, the release agent layer is separated or decomposed) as described above by, for example, irradiating the release agent layer with light from the support substrate side, and thereafter, for example, one of the substrates is pulled up, and the electronic device layer and the support substrate can be easily separated from each other.

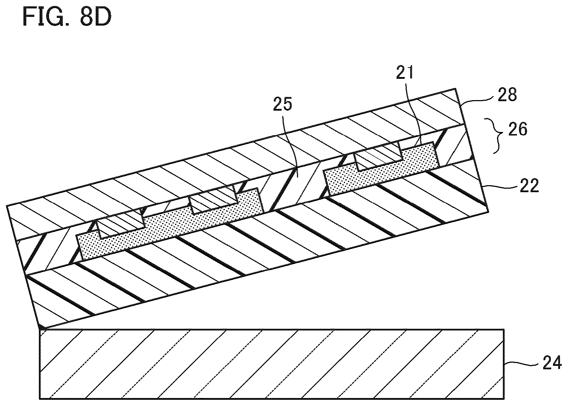

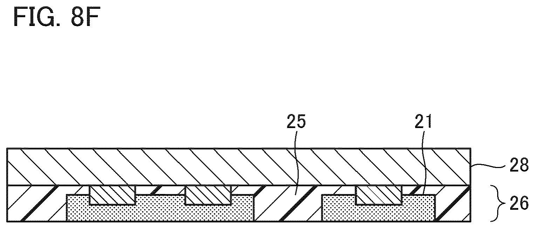

Figs. 8D to 8E are schematic cross-sectional views for describing a separation method for the laminate, and Fig. 8F is a schematic cross-sectional view for describing a cleaning method after separation of the laminate. One embodiment of the method for producing a semiconductor package (electronic component) can be described with reference to Figs. 8D to 8F.

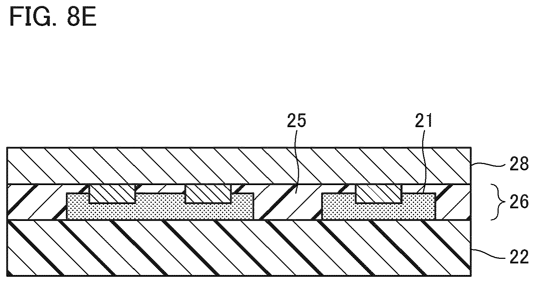

The step of separating the laminate is a step of separating the electronic device layer 26 and the support substrate 24 using a releasing device (not shown) as shown in Figs. 8D and 8E.

The substrate can be cleaned by spraying the cleaning agent composition onto the surface of at least one of the separated electronic device layer and the support substrate, or immersing the separated electronic device layer or the support substrate in the cleaning agent composition.

In addition, the surface of the processed electronic device layer or the like may be cleaned using a removal tape or the like.

For example, in Fig. 8E, the adhesive layer 22 adheres to the electronic device layer 26 after the separation step, but the adhesive layer 22 can be removed by decomposing the adhesive layer 22 using a cleaning agent composition such as an acid or an alkali. By removing the adhesive layer, a processed electronic device layer (electronic component) as shown in Fig. 8F can be suitably obtained.

The constituent elements and method elements related to the above-described steps of the method for producing a processed electronic device layer of the present invention may be variously changed without departing from the gist of the present invention.

The method for producing a processed electronic device layer of the present invention may include steps other than the above-described steps.

### Examples

Hereinafter, the present invention will be more specifically described with reference to Examples, but the present invention is not limited to the following Examples. Note that the apparatus used is as follows.

### [Apparatus]

(1) Stirrer A: rotation and revolution mixer ARE-500, manufactured by THINKY CORPORATION
(2) Stirrer B: AS ONE Corporation mixing rotor VMR-5R
(3) Stirrer C: Shinto Scientific Co., Ltd. Three-One Motor BLW-600.
(4) Spin coating device: coater manufactured by APOGEE Co., Ltd.
(5) Measurement of complex viscosity: Rheometer MCR-302 manufactured by Anton Paar Co., Ltd.

### [1] Preparation of Adhesive Composition

### [Example 1-1]

To a 100 mL glass container with a lid, 0.05 g of ethynyl p-toluenesulfonate (manufactured by Tokyo Chemical Industry Co., Ltd.) and 0.10 g of propylene glycol monomethyl ether acetate were added and stirred with a stirrer A for 5 minutes. Then, 8.54 g of a p-menthane solution (concentration: 81.4 mass%) of a vinyl group-containing MQ resin (manufactured by Wacker Chemie AG), and 1.16 g of a linear polydimethylsiloxane containing SiH groups with a viscosity of 100 mPa·s (manufactured by Wacker Chemie AG) were added and stirred with the stirrer A for 5 minutes to obtain mixture (I).

0.02 g of a platinum catalyst (manufactured by Wacker Chemie AG) and 3.66 g of vinyl group-containing linear polydimethylsiloxane (manufactured by Wacker Chemie AG) having a viscosity of 200 mPa·s were stirred with a stirrer B overnight to obtain a mixture (II).

To the mixture (I), 1.84 g of the obtained mixture (II) was added, and the mixture was stirred with the stirrer A for 5 minutes to obtain a mixture (III).

Finally, the obtained mixture (III) was filtered through a nylon filter 300 mesh to obtain an adhesive composition.

### [Comparative Example 1-1]

To a 100 mL glass container with a lid, 0.05 g of 2-(propynyloxy)benzaldehyde (manufactured by Tokyo Chemical Industry Co., Ltd.) and 0.10 g of propylene glycol monomethyl ether acetate were added and stirred with a stirrer A for 5 minutes. Then, 8.54 g of a p-menthane solution (concentration: 81.4 mass%) of a vinyl group-containing MQ resin (manufactured by Wacker Chemie AG), and 1.16 g of a linear polydimethylsiloxane containing SiH groups with a viscosity of 100 mPa·s (manufactured by Wacker Chemie AG) were added and stirred with the stirrer A for 5 minutes to obtain mixture (I).

0.02 g of a platinum catalyst (manufactured by Wacker Chemie AG) and 3.66 g of vinyl group-containing linear polydimethylsiloxane (manufactured by Wacker Chemie AG) having a viscosity of 200 mPa·s were stirred with a stirrer B overnight to obtain a mixture (II).

To the mixture (I), 1.84 g of the obtained mixture (II) was added, and the mixture was stirred with the stirrer A for 5 minutes to obtain a mixture (III).

Finally, the obtained mixture (III) was filtered through a nylon filter 300 mesh to obtain an adhesive composition.

### [Comparative Example 1-2]

To a 5000 mL glass container with a lid, 601.8 g of a p-menthane solution (concentration: 81.4 mass%) of a vinyl group-containing MQ resin (manufactured by Wacker Chemie AG), 81.1 g of SiH group-containing linear polydimethylsiloxane (manufactured by Wacker Chemie AG) having a viscosity of 100 mPa·s, and 115.9 g of vinyl group-containing linear polydimethylsiloxane (manufactured by Wacker Chemie AG) having a viscosity of 200 mPa·s were added, and stirred with a stirrer C until the mixture became uniform to obtain a solution.

Next, the prepared solution was stirred under reduced pressure at 70°C until the solid content concentration reached 94.4wt% to obtain a mixture (I).

Next, 2.6 g of 1,1-diphenyl-2-propyn-1-ol (manufactured by Tokyo Chemical Industry Co., Ltd.), 2.6 g of 1-ethynyl-1-cyclohexanol (manufactured by Wacker Chemie AG), and 16.6 g of p-menthane were stirred with a stirrer A for 5 minutes to prepare a mixture (II).

Thereafter, 3.5 g of the mixture (II) was added to the mixture (I), and the mixture (III) was stirred with the stirrer C until the mixture became uniform prepare a mixture (III).

1.1 g of a platinum catalyst (manufactured by Wacker Chemie AG) and 19.3 g of vinyl group-containing linear polydimethylsiloxane (manufactured by Wacker Chemie AG) having a viscosity of 200 mPa·s were stirred with a stirrer B overnight to obtain a mixture (IV).

Thereafter, 13.6 g of the mixture (IV) was added to the mixture (III), stirred with the stirrer C until homogeneous, and mixture (V) was obtained.

Finally, the obtained mixture (V) was filtered through a 300-mesh nylon filter to produce an adhesive composition.

### [2] Evaluation of Storage Stability

### [Fluidity]

Each of the adhesive compositions obtained in Example 1-1, Comparative Example 1-1, and Comparative Example 1-2 was stored at 23°C for a certain period, and the fluidity of the solution was visually confirmed every certain period to evaluate the storage stability of the solution. The evaluation results for each storage period are shown in Table 1.

In Table 1, the sample was rated "O" when no change was observed in the fluidity, and the sample was rated "X" when a change was observed. The unacquired data was set to

### [Change in Coating Film Thickness]

In addition, an adhesive composition of which the storage period was 0 days was applied to a 4 cm square silicon wafer by spin coating under a rotation condition (hereinafter referred to as a rotation condition A) in which the film thickness was about 60 µm, and heated at 120°C for 1.5 minutes and at 200°C for 1 minute to prepare a film, and the film thickness was confirmed.

An adhesive composition having a storage period of 3 days, 11 days, 21 days, or 28 days was applied by spin coating under the rotation condition A, and heated at 120°C for 1.5 minutes and at 200°C for 1 minute to prepare a film, and the film thickness was confirmed.

The film thickness evaluation results for each storage period are shown in Table 2.

As shown in Tables 1 and 2, it was confirmed that the viscosity of the adhesive composition obtained in Example 1-1 and Comparative Example 1-2 was not significantly changed in fluidity and film thickness even after storage at 23°C for 28 days, and the adhesive composition could be stored. Meanwhile, as shown in Table 1, it was confirmed that the adhesive composition obtained in Comparative Example 1-1 solidified even after storage at 23°C for 3 days after preparation of the composition and was deteriorated. Since the adhesive composition obtained in Comparative Example 1-1 solidified after being stored at 23°C for 3 days and was not spin-coated, the evaluation results after being stored for 3 days and thereafter were unmeasurable in Table 2.

**[Table 1]**

| | Confirmation of fluidity by visual observation | | | | |
|---|---|---|---|---|---|
| Storage period (days) | 0 | 3 | 11 | 21 | 28 |
| Example 1-1 | ○ | ○ | ○ | ○ | ○ |
| Comparative Example 1-1 | ○ | × | × | × | × |
| Comparative Example 1-2 | ○ | - | - | - | ○ |

**[Table 2]**

| | Film thickness (µm) | | | | |
|---|---|---|---|---|---|
| Storage period (days) | 0 | 3 | 11 | 21 | 28 |
| Example 1-1 | 56 | 56 | 56 | 58 | 58 |
| Comparative Example 1-1 | 57 | Spin coating not possible | - | - | - |
| Comparative Example 1-2 | 59 | - | - | - | 58 |

As described above, it was confirmed that the adhesive composition of the present invention exhibited good storage stability. Meanwhile, Comparative Example 1-2 to which an existing reaction inhibitor was added also showed good storage stability as in Example 1-1.

When ethynyl p-tolylsulfone was changed to methyl p-tolylsulfone in Example 1-1, the adhesive composition was cured immediately after preparation.

### [3] Evaluation of Curing Temperature

Each of the adhesive compositions obtained in Example 1-1 and Comparative Example 1-2 was applied to a 100 mm silicon wafer by spin coating, and heated at 120°C for 1.5 minutes (preheating treatment) to form an adhesive coating layer having a thickness of about 60 µm on a circuit surface of the wafer. The film was collected from the obtained film-coated wafer, and the complex viscosity was measured with a rheometer. The measurement results of the complex viscosity for each temperature in the range of 110°C to 170°C are shown in Table 3.

**[Table 3]**

| Temperature (°C) | Complex viscosity (Pa·s) | |
|---|---|---|
| | Example 1-1 | Comparative Example 1-1 |
| 110 | 16.0 | 31 |
| 120 | 9.4 | 25 |
| 130 | 6.1 | 150000 |
| 140 | 4.2 | 400000 |
| 150 | 3.0 | 500000 |
| 160 | 780 | 570000 |
| 170 | 37000 | 630000 |

As shown in Table 3, the viscosity of the adhesive composition obtained in Example 1-1 increased from 160°C as the temperature was increased, and the progress of crosslinking was confirmed. Meanwhile, the viscosity of the adhesive composition obtained in Comparative Example 1-2 increased from 130°C. From these results, it was confirmed that the curing start temperature of the adhesive composition of the present invention can be increased as compared with existing reaction inhibitors.

### Reference Signs List

- 1: Semiconductor substrate
- 2: Adhesive layer
- 2a: Adhesive coating layer
- 3: Release agent layer
- 4: Support substrate
- 21: Semiconductor chip substrate
- 22: Adhesive layer
- 22': Adhesive coating layer
- 23: Release agent layer
- 24: Support substrate
- 25: Sealing resin
- 26: Electronic device layer
- 28: Wiring layer

## Claims

1. An adhesive composition cured by a hydrosilylation reaction, containing
a platinum group metal-based catalyst and a compound represented by Formula (1) below: 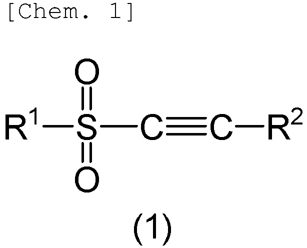
wherein in Formula (1), R¹ and R² each independently represent a monovalent group.

2. The adhesive composition according to claim 1, wherein R¹ in the Formula (1) represents an organic group having 1 to 20 carbon atoms.

3. The adhesive composition according to claim 1, wherein R² in Formula (1) represents a hydrogen atom, a halogen atom, or an organic group having 1 to 20 carbon atoms.

4. The adhesive composition according to claim 1, further containing: a component (A-1) having an alkenyl group having 2 to 40 carbon atoms bonded to a silicon atom; and a component (A-2) having an Si-H group.

5. The adhesive composition according to claim 4, wherein the component (A-1) contains a polyorganosiloxane (a1) containing an alkenyl group having 2 to 40 carbon atoms bonded to a silicon atom.

6. The adhesive composition according to claim 4, wherein the component (A-2) contains a polyorganosiloxane containing an Si-H group.

7. A laminate comprising:
a semiconductor substrate or an electronic device layer;
a light-transmissive support substrate; and
an adhesive layer provided between the semiconductor substrate or the electronic device layer and the support substrate, wherein
the adhesive layer is an adhesive layer formed from the adhesive composition according to any one of claims 1 to 6.

8. The laminate according to claim 7, comprising a release agent layer provided between the semiconductor substrate or the electronic device layer and the support substrate.

9. A method for producing a processed semiconductor substrate or a processed electronic device layer, the method comprising:
Step 5A of processing the semiconductor substrate of the laminate according to claim 7, or Step 5B of processing the electronic device layer of the laminate according to claim 7; and
Step 6A of separating the semiconductor substrate processed in the Step 5A and the support substrate from each other, or Step 6B of separating the electronic device layer processed in the Step 5B and the support substrate from each other.
